(19) Europäisches Patentamt / European Patent Office / Office européen des brevets

(11) **EP 2 951 925 B1**

(12) **EUROPEAN PATENT SPECIFICATION**

(45) Date of publication and mention
of the grant of the patent:
**15.07.2020 Bulletin 2020/29**

(21) Application number: **13704022.6**

(22) Date of filing: **31.01.2013**

(51) Int Cl.:
**H03M 13/11** *(2006.01)*

(86) International application number:
**PCT/EP2013/051829**

(87) International publication number:
**WO 2014/117836 (07.08.2014 Gazette 2014/32)**

(54) **LDPC CODE DESIGN AND ENCODING APPARATUS ENABLING THE ADJUSTMENT OF CODE RATE AND CODELENGTH**

LDPC-CODEDESIGN UND CODIERUNGSVORRICHTUNG ZUR EINSTELLUNG EINER CODEFREQUENZ UND CODELÄNGE

CONCEPTION DE CODES LDPC ET APPAREIL DE CODAGE PERMETTANT LE RÉGLAGE DU DÉBIT DE CODES ET DE LA LONGUEUR DE CODE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**09.12.2015 Bulletin 2015/50**

(73) Proprietor: **Intracom S.A. Telecom Solutions
19002 Paiania, Athens (GR)**

(72) Inventors:
• **KALATZIS, Charalampos
GR-19002 Paiania
Athens (GR)**
• **PANAYIOTOPOULOS, Ilias
GR-19002 Paiania
Athens (GR)**

• **KORATZINOS, Vassilios
GR-19002 Paiania
Athens (GR)**
• **VALKANAS, Antonios
GR-19002 Paiania
Athens (GR)**
• **TSAKIRIS, Stavros
GR-19002 Paiania
Athens (GR)**

(74) Representative: **Samuelides, Emmanuel
Leof. Alexandras 43
114 73 Athens (GR)**

(56) References cited:
**WO-A1-2006/062351**

**Description**

The invention relates to design, methods and apparatus for encoding and decoding information binary data through the use of **L**ow-**D**ensity **P**arity **C**heck (LDPC) codes for wireless telecommunication systems.

The continuous growth of high-speed wireless broadband telecommunication systems has been enforced by the increasing demand on more reliable and higher throughput to support novel applications and services. In order to detect and correct corrupted received signals from the wireless propagation medium, noise and interference, Forward Error Correction (FEC) codes that include redundancy in the encoded transmitted data packets are the most suitable solution since no feedback from the receiver to the transmitter is required. Recently, a class of FEC codes named Low-Density Parity Check (LDPC) codes has regain significant interest due to their ability to achieve near-Shannon limit capacity performances, their iterative decoding processing and their capability for parallel execution of certain encoding and decoding operations.

The encoding of LDPC codes is performed using a sparse parity check matrix H of size m rows and *n* columns with *m<n.* Matrix **H** is characterized as sparse since the majority of its elements are zero (usually with a proportion of zero elements greater than 80% of the total *m·n* elements of matrix **H**). The matrix **H** is a binary matrix composed of zeros and ones. A binary vector $\bar{c}$ of size 1 row by **n** columns is a valid codeword of the LDPC code defined by matrix **H** if the equation $H \cdot \bar{c}^T = \bar{0}$ in the modulo-2 Galois Field $GF_2$ is satisfied, where $\bar{0}$ denotes the all zero vector of size *m* rows by 1 column and $\bar{c}^T$ the transpose operation on vector $\bar{c}$. This property is characterizing LDPC codes as linear systematic block codes meaning that the input data are included into the encoded data, i.e. the codeword $\bar{c}$. Hence, using row operations, we can rewrite **H** as a function of a matrix **P** and the identity matrix $I_m$ of size *m* rows by *m* columns, i.e. $H=[P|I_m]$. Therefore, each codeword $\bar{c}$ is composed of the information data bits $\bar{x}$ of size 1 row by *n-m* columns and the parity bits $\bar{p}$ of size 1 row by *m* columns. Hence, the matrix **H** is defining a set of *m* parity check equations each of which involves a specific group of information and parity bits that must sum to zero modulo 2. The code rate of the encoding with a matrix **H** is characterized by the ratio r given by the size of the information bits with the size of encoded bit i.e.

$$r = \frac{n - m}{n} = 1 - \frac{m}{n}.$$

All LDPC codes and their matrices **H** can be represented by bipartite graphs also called Tanner graphs. In a Tanner graph, nodes are split into two groups, the variable nodes that are associated to the codeword bits and the check nodes that correspond to the set of parity-check constraints of the code. Variable and check nodes are connected through edges. Each variable node is associated to a column of **H** and each check node to a row of **H.** The presence of a non-zero value, i.e. a 'one' in matrix **H** identifies an edge connection between the variable and check nodes that are associated to the corresponding column and row. A path in a (Tanner) graph is a sequence of nodes such that from each of its nodes there is an edge to the next node in the sequence. A finite path has always a first node called start node and a last node called end node. A cycle is a finite path with its start and end nodes are the same. The girth of a graph is the length of the shortest cycle contained in a graph.

The encoding process of LDPC can be performed using the generator matrix **G** of the code of size *n-m* rows by *n* columns. The generator matrix **G** must satisfies the equation $G \cdot H^T = \bar{0}$, where $\bar{0}$ denotes the all zero matrix of size *n-m* rows by *m* columns and $H^T$ the transpose operation on matrix **H**. Then, for each information data or block of data $\bar{x}$, the codeword $\bar{c}$ of the LDPC code can be obtained by $\bar{c} = \bar{x} \cdot G$. The vector multiplication with matrix **G** can be parallelized by splitting the multiplication process to operations performed on distinct columns of **G**.

For the decoding of LDPC codes, a general mostly used methodology applied by the decoders is the implementation of an exchanging messages algorithm among registers. This means that the values in registers of the decoders are updated based on a certain algorithm and the values or messages provided by other registers. Then, these updated values correspond to messages provides to other registers for the calculation of their updated values. The registers are associated to the nodes of the Tanner graph of the LDPC code. The connections allowed among registers for the transfer of messages are determined by the edges of the Tanner graph given by the parity check matrix **H.** Initially, each register representing variable nodes are set to values characterizing the estimation of the value of the corresponding codeword bit. Computations in each register are performed based on the incoming messages and the type of node in the Tanner graph. The message exchange process is iteratively repeated until specific conditions are met, for example until the estimations of the codeword bits satisfy the condition $H \cdot \bar{c}^T = \bar{0}$.

Typically, in LDPC codes, parity check matrices **H** are designed for a particular code rate and for a predetermined codeword length. This means that not only both values *m* and *n* are predetermined but also the ratio value *r* is fixed. This leads to the implementation of a specific architecture at both encoder and decoder that cannot accommodate packets $\bar{x}$ of variable sizes nor support different code rates. Therefore, there is tremendous interest in the dimensioning of generalized LDPC encoding and decoding implementation architectures capable to support various codeword lengths and code rates that can exploit efficient designs and compositions of the parity check matrices **H.**

WO2006062351 discloses an LDPC encoder using one "mother" parity check matrix composed of circular sub-matrices (and having a triangular structure); other code rates are obtained by deleting some rows of the parity check matrix or by combining rows ("row merging"). In this prior art encoding method, shortening is performed by padding of zero bits and linear encoding by using the triangular property of the parity check matrix.

The object of the invention is an apparatus and a method for the processing of blocks of data bits with Low-Density Parity Check codes, which are efficient and enable simultaneously the selection of encoding parameters that suit the needs of the communication channel and the definition of the parity check matrix without the need of time consuming computations.

The invention is defined in the independent claims. The apparatus and the method according to the invention enable the implementation of a unique family of parity check matrices, which supports a cost-effective selection of the codeword length and code rate in terms of computations and hardware. In addition, the invention is appropriate for efficient parallelization.

Optional features that are related with further advantages of the invention are defined in the dependent claims. An apparatus or a method according to the invention may comprise one or more of the optional features in combination.

The invention allows the user to select the code rate and/or the codeword length by selecting a first parameter that defines the number of first level blocks across a column of the parity check matrix and a second parameter that defines the size of the $1^{st}$ Level circulant blocks. Since all $1^{st}$ Level, $2^{nd}$ Level and $3^{rd}$ Level blocks are rectangular, the size of the blocks is described by a single integer that corresponds to the number of the columns or rows. It is also noted that the size of subdivision of a higher level block is the number of lower level blocks along a line and across a column of the higher level block. In the case of rectangular blocks the two numbers coincide.

Preferably the processing means of an apparatus according to the invention includes a sign shifter means that is configured to perform flipping operations, i.e. reversing the order of entries, over sets of bits based on a shift parameter obtained by the controller.

The apparatus may include a Sparse Matrix Multiplier (SMM) that is used for consecutive processing of the same block of data or more than one sparse matrix multipliers (SSM's). In the former case the apparatus includes means to receive the output of the SSM and re-direct it to it. The output has the same dimensions as the input. In the latter case the input of a SSM is forwarder to the following. SSM's may be also arranged in parallel.

The shift parameters that define the circulant blocks are obtained from a unique controlling parameters and shift parameters that define a master rectangular block than any of the circulant blocks. Preferably, the apparatus may comprise storage means, which are configured to store the shift parameters defining the master rectangular block, input means configured to obtain the unique controlling parameter and processing means configured to determine the shift parameters from the shift parameters defining the master rectangular block and the unique controlling parameter.

The parity check matrix, which is used for the encoding is subdivided into $\alpha \times \beta$ rectangular blocks of size q so that the parity check matrix is composed of $q \times \alpha$ rows and $q \times \beta$ columns with $\alpha$ and $\beta$ being non-zero integer positive numbers, the rectangular blocks of size q are further subdivided into $\gamma \times \gamma$ rectangular blocks of size v, so that the rectangular blocks of size q are composed of $v \times \gamma$ rows and $v \times \gamma$ columns with $\gamma$ being non-zero integer positive number and the rectangular blocks of size v are further subdivided into $\delta \times \delta$ rectangular blocks of size w, so that the rectangular blocks of size v are composed of $w \times \delta$ rows and $w \times \delta$ columns with $\delta$ being non-zero integer positive number. The user may set a maximum value for $w \times \delta$ for a set of bits and each packet of bits is split into a series of sets of equal number of information bits, whereby each set includes no more than the maximum value $w \times \delta$. The maximum value of $w \times \delta$ could be equal to a power of 2, preferably 32. $\delta$ may be also equal to a power of 2, preferably 8. The code rate can be controlled by selecting the value of $\alpha$. The codeword length, i.e. the number of bits of the codeword is controlled by the dimensions of q through the selection of $\delta$. In a preferred embodiment of the invention w is selected equal to 4.

Embodiments of the invention will be described with reference to **Figures 1 to 8,** whereby:

> **Figure 1** shows the composition of the parity check matrix **H** from its sub-matrices **A, C, B, D, E** and **T.**
> **Figure 2** shows an example of the cyclic representation of 3 Levels of squared blocks **of H.**
> **Figure 3** shows an example of positive and negative cyclic shifts of a block.
> **Figure 4** shows an example of the compression transformation of square block **of H.**
> **Figure 5** shows an example of selection of Level-2 shift values based on value **L.**
> **Figure 6** shows an example of rate transformation of sub-matrices **B, D, E, T** and **T⁻¹.**
> **Figure 7** shows the diagram of the encoding process of the LDPC codes.
> **Figure 8** shows the diagram of the multiplication of a sparse matrix multiplier component.

The paragraphs below include a description of the structure and methodology for the construction of LDPC code parity matrices and, the transforms that convert them in order to support variable code rates and codeword lengths following by a description of the encoding architecture that exploit such family of LDPC codes. Examples illustrated by drawings are also given to describe and further clarify the examples of the invention. However, the examples are not limiting the invention that can be used for the definition of a wide variety of families of LDPC codes.

## LDPC Codes Design

As mentioned at the beginning of this document, channel coding LDPC is mainly characterized by a parity check matrix **H** composed of binary values: zeros and ones. Even though, the composition of matrix **H** can be arbitrary, it is possible through simple row and column permutations to convert it into a format with all zeros into its upper right part (see Thomas J. Richardson and Rüdiger L. Urbanke, «Efficient Encoding of Low-Density Parity-Check Codes», IEEE Transactions on Information Theory, Vol. 47, No. 2, February 2001, pages 638-656). It can then be split into a set of sub-matrices namely **A, B, C, D, E** and **T**. This partitioning is led by sub-matrix **T** that is defined to be a lower triangular rectangular matrix. According to the dimensions of **T,** the dimensions of sub-matrices **A, B, C, D,** and **E** can be obtained. The number of non-zero values in these last 5 sub-matrices is arbitrary. In linear block codes such as LDPC, decoding is usually performed using matrix **H** while encoding is performed using the generator matrix **G.** The above mentioned representation of matrix **H** leads to a simple encoding process performed following a series of steps using the sub-matrices of **H,** certain of which can be carried out in parallel. Therefore, a significant advantage of this implementation is that only storage of matrix **H** is required for both encoding and decoding processes. The encoding process based on matrix **H** is described below. Decoding using the above described families of sparse parity matrices **H** can be performed using a typical LDP decoder based on Min-Sum algorithm. In the preferred embodiments of the invention, we define a specific set of constraints to the dimensions and compositions of all sub-matrices of **H** in order to reduce storage requirements, provide support of different code rates and codeword lengths with no modifications of the system architecture, and simplify both encoding and decoding operations. This set of constraints defines a family of parity check matrices **H** with different code rates and different sizes that can be used by a unique encoding and decoding architecture to accommodate variable codeword lengths and code rates.

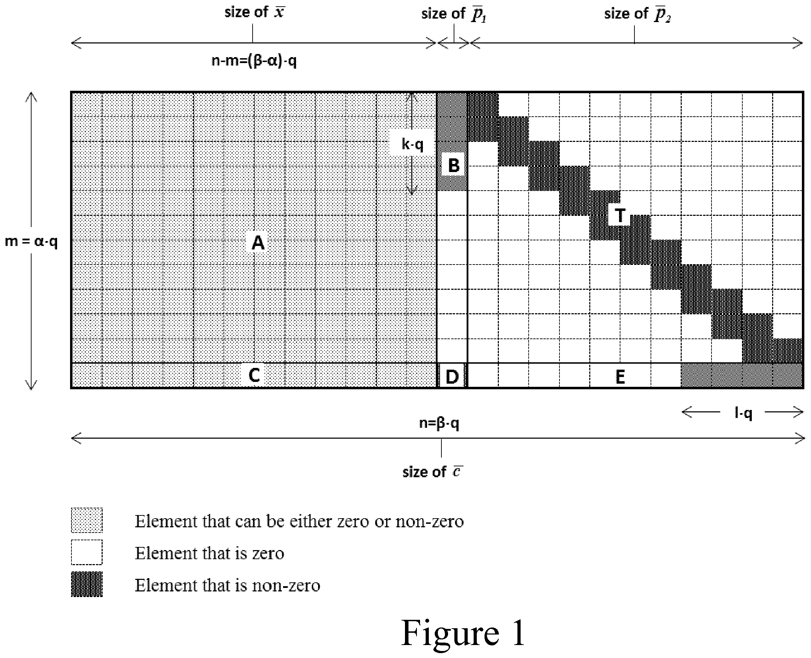

A sparse parity check matrix **H** belonging to a family of parity check matrices is initially determined by its subdivision into rectangular blocks of a predefined size *q,* i.e. having *q* lines and columns. This implies that the dimensions *m* and *n* of matrix **H,** i.e. the number of rows and columns of matrix **H,** are multiples of *q.* Therefore, by naming $\alpha$ the number of rectangular blocks of size **q** across a column of matrix **H** and by $\beta$ of rectangular blocks of size **q** along a row of matrix **H,** i.e. the size of subdivision of matrix **H** is $\alpha \times \beta,$ the matrix **H** is subdivided into the following 6 sub-matrices as shown in **Figure 1:**

- matrix **A** of size *($\beta$-$\alpha$)·q* by *($\alpha$-1)·q*
- matrix **B** of size *q* by *($\alpha$-1)·q*
- matrix **C** of size *($\beta$-$\alpha$)·q* by *q*
- matrix **D** of size *q* by *q*
- matrix **E** of size *($\alpha$-1)·q* by *q*
- matrix **T** of size *($\alpha$-1)·q* by *($\alpha$-1)·q*

More analytically, we define a non-zero integer positive number **q** such that matrix **H** of the family of sparse parity check matrices is composed of *q·a* rows and *q·$\beta$* columns with $\alpha$ and $\beta$ defined as non-zero integer positive numbers.
The first constraint on the design of the family of matrices **H** is that the number $\beta$ is constraint to a constant value. The support of different codeword lengths through the definition of the size *n* of the family of matrices **H** is determined by controlled modifications of the size *q* as described below. The code rate **r** is defined as the ratio of the

$$r = \frac{n-m}{n} = 1 - \frac{m}{n} = 1 - \frac{\alpha \cdot q}{\beta \cdot q} = 1 - \frac{\alpha}{\beta}.$$

information bits lengths divided by the codeword length, i.e. Since the number $\beta$ is fixed and $\alpha<\beta,$ the different code rates supported by the system are given by changing $\alpha$ as described in the following paragraphs. The matrices **H** determined by different values of $\alpha$ determine a family of parity matrices of different code rates. For each of these matrices, the matrices **H** obtained by modifications of the size **q** determine a family of parity matrices of different codeword lengths for the code rate determined by the value of $\alpha.$ All these matrices determine the general family of matrices supported by the system providing encoding of variable code rate and codeword lengths.

As an implementation example, we consider throughout this document that $\beta$=24. Also, we determine a specific set of possible values for $\alpha\varepsilon$*{12, 6, 5, 4, 3}.* For these values *of* $\alpha$ and $\beta$, we have the following possible code rates supported by the system *r* $\in${0.5, 0.75, 0.792, 0.833, 0.875}.

We define as zero rectangular block, any rectangular matrix that has all its elements equal to zero. Equivalently, any rectangular matrix that has at least one of its elements non-zero is defined as a non-zero rectangular block. In fact, as we will show later on, each non-zero **q** block has exactly **q** non-zero elements. Then, we can define the following set of general constraints on the composition of the sub-matrices of **H** in terms of zero or non-zero blocks of size **q**:

- • There is no constraint on the number of non-zero and zero **q** blocks allowed in sub-matrices **A** and **C**.
- • Matrix **D** is constraint to be composed of a non-zero **q** block.
- • Matrix **T** is constraint to contain non-zero elements only in the **q** blocks of its diagonal and the **q** blocks directly underneath this diagonal as shown in **Figure 1**. This means that if $x$ is the number identifying the column position of a **q** block of **T** and $y$ is the number identifying the row position of a **q** block of **T**, i.e. $x \in [1; (\alpha-1)]$ and $y \in [1; (\alpha-1)]$, then a **q** block contains non-zero elements if and only if the following conditions are satisfied: $x=y$ or $y=x+1$.
- • Finally, we define by **k** the number of non-zeros **q** rectangular blocks placed on the top rows of sub-matrix **B** and by **l** the number of non-zeros **q** rectangular blocks placed in the right columns of sub-matrix **E** as shown in Figure 1. All other **q** rectangular blocks of matrices **B** and **E** are zero blocks. In our implementation example, we set **k=2**, i.e. matrix **B** has only 2 non-zero blocks **q** rectangular blocks placed on the top rows **of B**. Also, we can set **l=1**, i.e. matrix **E** has only 1 non-zero blocks **q** rectangular blocks placed on the right columns of **E**.
- • For implementation purposes, we set a general constraint on the total number $\eta$ of non-zero **q** blocks allowed in the entire matrix **H** for all code rates supported. The constraint on $\eta$ is such that the number of non-zero elements in the entire matrix **H** must not exceed $\eta$. With this constraint, the number of encoding and decoding operations that are bounded by the operations performed on the non-zero **q** blocks of the sparse matrices can be predetermined.

Since non-zero blocks in matrices **D, T, B** and **E** are constraint, we can determine the number of non-zero blocks allowed in matrices **A** and **C**. This establishes the maximum number of non-zero **q** blocks in all sub-matrices of **H**. For our implementation example, in the case where $\alpha=4$, then the number of non-zero **q** block in matrix **T** are **5**. The number of non-zero blocks in **D, B**, and **E** are 1, 2 and 1 respectively. Hence, by setting our constraint $\eta=85$, the number of non-zero blocks in matrices **A** and **C** is **85-5-2-1-1=76** that are distributed in the **4·(24-4)=80** rectangular **q** blocks of matrices **A** and **C**. Notice, that for $\alpha=3$ and $\eta=85$ the number of non-zero blocks in matrices **A** and **C** is **85-3-2-1-1=78** but the size in **q** blocks of matrices **A** and **C** is **3·(24-3)=63** that is smaller than **78**. In this case, all **q** blocks of matrices **A** and **C** are non-zero blocks.

As described above, we define a specific set of constraints on the design of families of parity matrices **H** and the transformation functions of these matrices **H** targeting the accommodation of codewords of various lengths and various rates. We include an extension of the construction of these matrices **H** aiming to provide additional performance robustness to the LDPC codes.

Based on these constraints and conversions, we propose implementation methods for the encoding of sparse sub-matrices of **H** optimized in terms of operations required and capable to support under a unique architecture various codeword lengths and code rates without modification of the implementation and storage requirements.

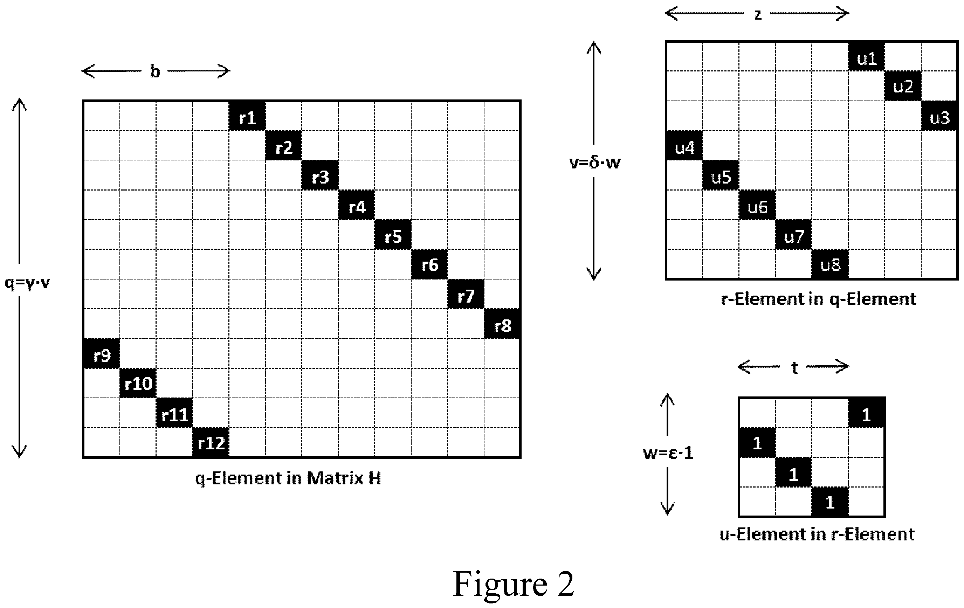

Following the subdivision in rectangular blocks described above, we extend this decomposition by imposing that sparse parity matrix **H** can be subdivided into rectangular blocks of a specific size that can in their turn be subdivided into rectangular blocks of a specific size and so on. We declare that each subdivision of a predefined size and corresponding rectangular blocks define a Level of representation of matrix **H**. The invention suggests at least three subdivisions and consequently 3 Levels of representation of the matrix **H**. Hence, each rectangular block of size **q** of matrix **H** can be further subdivided into rectangular blocks of size **v** which in their turn can also be subdivided into rectangular blocks of size **w** and so on. In the embodiments of the invention we consider that there are only 3 levels of subdivision of blocks, i.e. a block **q** (Level-1) noticed as q-Element is composed of blocks **v** (Level-2) noticed as r-Elements that are composed of blocks **w** (Level-3) noticed as u-Elements as shown in **Figure 2**. Hence, we can denote by $\gamma$ the number of rectangular blocks of size **v** aligned in each row or column of a block **q**, by $\delta$ the number of rectangular blocks of size **w** aligned in each row or column of a block **v** and by $\varepsilon$ the number of 1's in a row or column of a block **w**. Then, we have **q=$\gamma$·v, v=$\delta$·w** and **w=$\varepsilon$·1**. The above described subdivisions are applied to the entire matrix **H** meaning that the subdivision sizes **q, v** and **w** of all 3 Levels are constant for the entire matrix **H**.

Aiming at a simplified implementation of the specific 3-level representation of matrices **H**, we constraint the size of the final third level **w** to be constant. For our implementation example, we set **w=$\varepsilon$=4**. This constraint is offering a significant advantage in the encoding process since operations can be performed in blocks of input data of size equal to **w**. This is an important benefit compared to other decomposition based on only 2 levels since the additional Level-3 offers the possibility to encode larger number of information bits (due to larger size sparse matrices) performing an equivalent number of encoding operations in parallel.

For the usage of different codeword lengths, we constraint $\gamma$ to be fixed and modify only the size $\delta$ following a specific methodology described in the following paragraphs. For our implementation example we set $\gamma=21$.

For each non-zero block (named in this paragraph higher block) of any of the three levels of representation of **H**, the non-zero blocks or elements (named here as lower blocks or elements) of the level underneath it are following a quasi-cyclic representation based on right cyclically shifting the non-zero lower blocks or elements positioned in the diagonal of the higher block as shown in **Figure 2.** This corresponds to the determination circulant matrices that are formed from cyclic permutation of a diagonal matrix. This implies that only one non-zero lower block or element is placed per row and column of the higher block. In addition, only one value, namely the shift value, is needed, as we will describe below, to determine the position of all non-zero lower blocks within a higher block. Hence, for Level-1 blocks of size *q*, we denote by *b* the number of *r* blocks or of Level-2 required for right shifting the diagonal r-Elements of size *r* within the *q* block. For consistency, if *b* is zero, there are no non-zero r-Elements in Level-1 block. Therefore, *b* can take integer values from *0* to $\gamma$. Similarly, we denote by z the right shift value of Level-2 of *u* blocks or u-Elements. The shift value *z* can take integer values from *0* to $\delta$. Following the same notation, we denote by *t* the shift of Level-3 blocks taking values from *0* to $\varepsilon$. We notice that since the same cyclic representation is applied to all defined Levels, each block of any Level has only one non-zero value in each of its row or column. We can also notice that if a block of any of the three levels of representation has a non-zero shift value than there exist blocks of any level belonging or underneath this block that must contain non-zero shift values.

Hence, following our implementation example, the values supported are $b \in [0; 21]$ with the value *0* meaning that all elements of block *q* are zero blocks. The value *1* corresponds to have non-zero Level-2 *r* blocks that follow the diagonal within the Level-1 *q* block. Since we have set *w=4,* the shift value *t* belongs to the interval *[0; 4].* As we will see in the following paragraphs, the size of Level-2 is modifiable to make possible the support of different codeword lengths. In our example as we will show below the values of $z \in [0; 8]$.

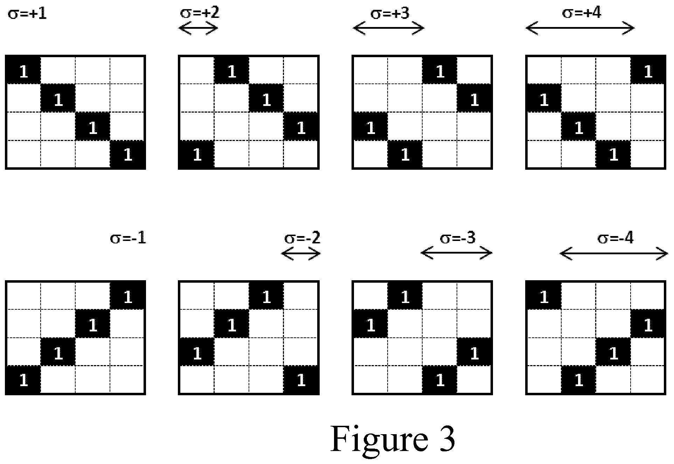

As described before, we consider the implementation of predetermined circular permutations applied over the rows of square matrices of any Level of matrix **H** based on a shift value. Hence, we can consider a square matrix block of size *i* (which can be either *q, v* or *w* block) composed of square elements *e* and $\sigma \in [1; i]$ the right shift value identifying circular permutation applied to the diagonal elements e of the block. Then an element *e* of the block *i* that is identified by the position *(x, y)* with its column position $x \in [1; i]$ and its row position $y \in [1; i]$ is non-zero if the condition $x = mod_i[(y-1)+(\sigma-1)]+1$ is satisfied given that $mod_i[.]$ defines the modulo-i operation. We further extend the circular permutation in rectangular blocks of matrix **H** by considering the application of left shifts of the anti-diagonal matrix which is defined as the matrix with its non-zero elements placed in the diagonal going from the lower left corner to the upper right corner. Hence, we can assume a square matrix block of size *i* (which can be either *q, v* or *w* block) composed of square elements *e* and $\sigma \in [-1; -i]$ the left shift value identifying circular permutation applied to the anti-diagonal elements *e* of the block. Then, an element *e* of the block identified by the position *(x, y)* with its column position $x \in [1; i]$ and its row position $y \in [1; i]$ is non-zero if the condition $x = mod_i[-y+(\sigma+1)]+1$ is satisfied. An example of such left shifts is shown in **Figure 3** for Level-3 blocks of size 4. In this case, the shift values can also take negative values. Following this extension, we can redefine the intervals of the shifts of our three levels representation of matrix **H** as $b \in [-\gamma; +\gamma]$, $z \in [-\delta; +\delta]$ and $t \in [-\varepsilon; +\varepsilon]$ considering that the value *0* is used to identify the non zero block. The main advantage of this extension with circular permutation of the anti-diagonal comes from the simple reduction of the number of girths in matrix **H**. Firstly, by doubling the possible circular representations of non-zero values in blocks, the possible combinations of blocks in matrix **H** are significantly increased which reduces the number of girths counted. Secondly, when only positive (or negative) shifts are used, the number of girths - if existing - is always equal to the size of the blocks involved in the girth computation. However, when combinations of positive and negative circular shifts are used, the number of girths is either equal to the size of the blocks involved in the girths estimation or equal to 1.

In the preferred embodiment of the invention, we impose that Level-1 shifts are only positives. Hence, in our implementation example, we still have $b \in [0; 21]$. However, Level-2 shifts become $z \in [-8; 8]$ and Level-3 shifts $t \in [-4; 4]$. In these last two cases, the value -1 corresponds to a distribution of the non-zero sub-blocks belonging to the block of Level-2 or Level-3 that follows the anti-diagonal matrix as shown in **Figure 3.**

From the above we deduce that for each block of any level only a shift value is necessary for the identification of the positions of non-zero sub-blocks. Hence, we need one $b \in [0; +\gamma]$ shift value for each of the Level-1 square blocks of matrix **H**, i.e. a total of different $\alpha\beta$ values. Since, zero Level-1 blocks of matrix **H** do not include any non-zero Level-2 blocks we consider the non-zero Level-2 shifts applied only to the non-zero Level-1 blocks of matrix **H**. Therefore, for each non-zero Level-1 block having a shift value $b \neq 0,$ we need $\gamma$ values for the representation of shifts $z \in [-\delta; +\delta]-\{0\}$ of its Level-2 blocks. Hence, considering $\eta$ the number of non-zero blocks of size *q* in the entire matrix **H,** we need a total of $\eta \cdot \gamma$ non-zero shift values. Then, for each of these non-zero Level-2 blocks, we need $\delta$ values for the representation of shifts $t \in [-\varepsilon; +\varepsilon]-\{0\}$ of its Level-3 blocks. This gives a total of $\eta \cdot \gamma \cdot \delta$ non-zero shift values. Hence, in total, a matrix **H** is represented by $a \cdot \beta + \eta \cdot \gamma + \eta \cdot \gamma \cdot \delta = \alpha \cdot \beta + \eta \cdot \gamma(1+\delta)$ shift values. We can reduce this total number of shift values required for the representation and storage of all non-zero elements of the entire matrix **H** by imposing, in this invention, a constraint in the shift values of Level-3 blocks. We constraint to all non-zero Level-3 u-Elements of a Level-2 r-Element having a shift value *z* to have the same shift value *t* with a sign equal to the sign of shift value z. In this case, we can define a common shift value *s* that integrates the shifts of both Level-2 and Level-3 blocks. The shift value *s* can be obtain from *z* and *t* through the equation $s = sign(z) \cdot \varepsilon \cdot (|z|-1)+sign(z) \cdot |t|$ with *sign(.)* being the sign operation and |.| being the absolute operation. We have $s \in [-\delta e; +\delta \varepsilon]-\{0\}$. With this shift numbers restriction, only one shift value is needed for the identification of non-zero elements in a Level-2 block and its corresponding Level-3 blocks. Hence, the entire matrix **H** can be represented by a total of $a \cdot \beta + \eta \cdot \gamma$ shift values. Notice that the shift values **z** and **t** can be obtained from shift value **s** using

$$z = sign(s) \cdot \left[ floor\left(\frac{|s|-1}{\varepsilon}\right) + 1 \right] \qquad t = sign(s) \cdot \left[ rem\left(\frac{|s|-1}{\varepsilon}\right) + 1 \right]$$

the following equations, with $sign(.)$ being the sign operation, |.| being the absolute operation, $floor(.)$ being the floor operation of a real number, i.e. the larger integer not greater than the real number and $rem(.)$ being the remainder operation of the division of two integers.

Following our implementation example, under the above mentioned constraints and having set $\delta=8$ and $\varepsilon=4$, we have $s \in [-32; 32]$. Hence, as an example, in order to get the common shift value s from the shift values $z=-5$ and $t=-3$, we apply $s=sign(-5) \cdot 4 \cdot (|-5|-1) + sign(-5) \cdot |-3| = (-1) \cdot 4 \cdot 4 + (-1) \cdot 3 = -19$. Notice that z and $t$ must have the same sign, i.e. be both cyclic shifts of either diagonals or anti-diagonals matrices. In order to restore the shift values **z** and **t** from the shift value $s=-19$, we apply

$$z = sign(-19) \cdot \left[ floor\left(\frac{|-19|-1}{4}\right) + 1 \right] = (-1) \cdot \left[ floor\left(\frac{18}{4}\right) + 1 \right] = (-1) \cdot [4+1] = -5$$

$$t = sign(-19) \cdot \left[ rem\left(\frac{|19|-1}{4}\right) + 1 \right] = (-1) \cdot \left[ rem\left(\frac{18}{4}\right) + 1 \right] = (-1) \cdot [2+1] = -3$$

Since we have fixed sizes $\gamma$ and $\varepsilon$ for Level-1 and Level-3 blocks respectively, we constraint the size $\delta$ of Level-2 blocks to belong to a constraint set of positive integers $\Delta$. In fact, we constrain all non-zeros Level-2 rectangular blocks of matrix **H** to have dimensions equal to $v=n \cdot \varepsilon = n \cdot w$ with $n$ being a value from a constraint set $\Delta$ of positive integers. Hence, for each value of $n$, all Level-2 blocks of **H** will be of the same size $v=n \cdot \varepsilon = n \cdot w$ defining a partitioning into blocks of matrix **H**. All different values of the set $\Delta$ serve to define a family of matrices **H** of different sizes that can be used for the encoding of different codeword lengths. We set an additional constraint on the values $n \in \Delta$ to be on the form $n=2^N$ with $N \in [0; K-1]$ with $K$ being a predetermined positive integer determining the number of different codeword lengths supported by the LDPC encoder and decoder. Hence, for example, if $w=4$ and $K=4$, then $N=\{0, 1, 2, 3\}$, $\Delta=\{1, 2, 4, 8\}$ and $v=\{4, 8, 16, 32\}$. Following the above mentioned constraint, it becomes possible to re-dimension Level-2 block $v_n=2^n \cdot w$ to block $v_{n-1}=2^{n-1} \cdot w$ by reducing the number of rows and columns of the Level-2 block to half. This re-dimensioning method can be repeated starting from $v_{K-1}=2^{K-1} \cdot w$ until $v=w$. We notice that since parameters $\beta$, $\gamma$, and $\varepsilon$ are fixed, the set $\Delta$ is defining different horizontal dimensions of a family of matrices **H** and parameter $K$ can be used for the characterization of the horizontal dimensions of this family of matrices. Hence, parameter $K$ is giving the number and the sizes of the different codeword lengths supported by the system.

Having determined a methodology to modify the size of Level-2 blocks, we need to determine a methodology to convert the shift values applies to Level-2 block with a higher power of 2 to shift values for Level-2 block of a lowest power of 2. Hence, assuming that $z_n$ is the shift value determined to Level-2 block $v_n$ then the shift value $z_{n-1}$ of the re-

$$z_{n-1} = sign(z_n) \cdot \left[ floor\left(\frac{|z_n|-1}{2}\right) + 1 \right].$$

dimensioned Level-2 block $v_{n-1}$ is obtained from the equation

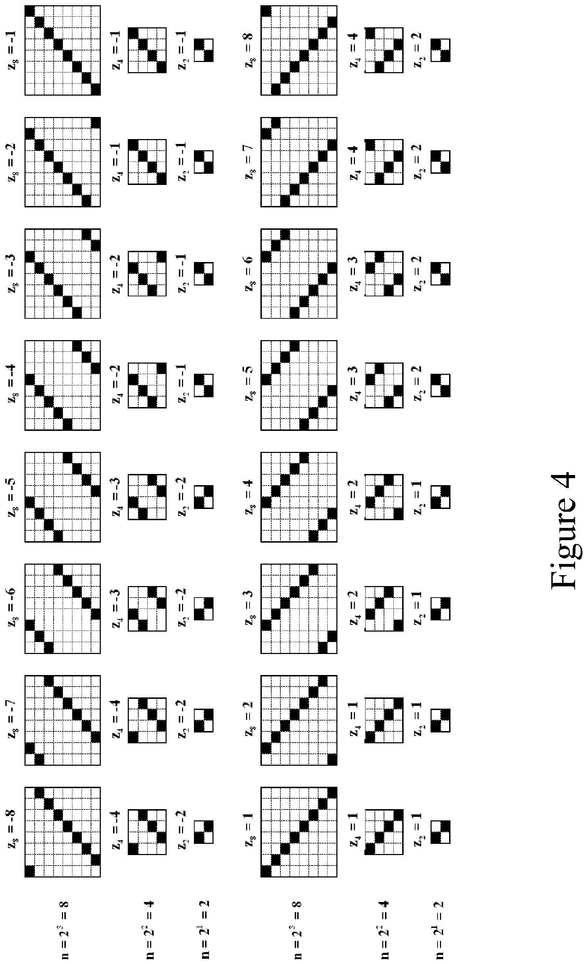

An example of the re-dimensioning of Level-2 blocks and the operations to obtain the equivalent shift values is shown in **Figure 4** assuming that $K=4$. In that case, we have $N \in \{0, 1, 2, 3\}$ and $\Delta \in \{1, 2, 4, 8\}$. Then, for Level-2 size $v_8=8$, we have shift values $z_8=\{-8, -7, -6, -5, -4, -3, -2, -1, 1, 2, 3, 4, 5, 6, 7, 8\}$. The equivalent shift values for $v_4=4$ are given by $z_4=\{-4, -4, -3, -3, -2, -2, -1, -1, 1, 1, 2, 2, 3, 3, 4, 4\}$. After further re-dimensioning of Level-2 blocks to $v_2=2$, we obtain the equivalent shift values $z_2=\{-2, -2, -2, -2, -1, -1, -1, -1, 1, 1, 1, 1, 2, 2, 2, 2\}$.

We notice that the re-dimensioning transformation function of the shift values described above is not bijective meaning that we can obtain shift value $z_{n-1}$ from shift value $z_n$ but we cannot perform the inverse operation, i.e. obtain shift value $z_n$ from shift value $z_{n-1}$. This implies that the shift values used for all families of matrices **H** and the set of possible codeword lengths given by the values within $\Delta$ can be determined by the shift values defined for the maximum supported codeword length identified by the value of $K$. Hence, with the above methodology of characterization of the set of families of matrices **H** of different codeword lengths, we need to determine and store only the shift values corresponding to the highest power of 2 in set $\Delta$, i.e. those corresponding to the value of $K$. The shift values for $K$, its sparse matrix and the rectangular blocks of Level-1 composing it can be identified as master shift values, master matrix and master rectangular blocks from which other shift values, sparse matrices and rectangular blocks can be obtained for lower codeword lengths.

For our implementation example, we have Level-2 block sizes $\delta \in \{1, 2, 4, 8\}$ that define a set of family of matrices **H** and can be used to determine the different codeword lengths supported by the system given by $\beta \cdot q = \beta \gamma \delta \varepsilon$. It is possible to store the corresponding Level-2 shift values *z* and Level-1 shift values *t* (or simply their combined shift value s) for each different value $\delta$. However, thanks to the formulation of $\delta$ as a power of 2 and the transformation function previously defined for the computation of shift values after re-dimensioning of Level-2 blocks, only the shift values corresponding to the highest power of 2 are needed for storage. In fact, we can exploit the binary signed representation of an integer value so simplify the implementation of operations such as sign, floor, absolute value, remainder and division or multiplication by 2. Hence, for example, the shift value *s=-19* corresponding to shift values *z=-5* and *t=-3* can be represented by 1 bit for the sign and 5 bits for its absolute value giving '110011'. We notice that '10011' can be split into two parts the first 3 bits '100' which is a value equal to Level-2 shift value $|z|$-*1=5-1=4* and the next 2 bits '11' which is a value equal to Level-3 shift value $|t|$-*1=3-1*. For the re-dimensioned Level-2 block the new shift value is given by performing a division by 2 of the previously shift value *z*, i.e. by taking only the left 2 bits out of the 3 bits which gives '10' a binary value equal to *2*. Hence, the new shift value for the re-dimensioned Level-2 block is '11011' which give a new $|z|$*=2+1=3*. This defines the new shift value *s=-11*. We notice that this binary transformation correspond to the

$$-3 = sign\left(-5\right) \cdot \left[ floor\left( \frac{|-5|-1}{2} \right) + 1 \right] = (-1) \cdot [2 + 1] \; .$$

equation                                                                                                          The above binary operations on shift values can be carried out for all different values of $\delta$ i.e. different codeword lengths. Therefore, we need to store only the shift values for the highest possible value of $\delta$ that in our example is equal to *8*. This means that from the shift values *s* $\in$ *[-32, 32]* we can recover the shift values for all different codeword lengths and determine a different matrix **H** of a family of sparse parity matrices with variable codeword lengths. An additional advantage of this operation is that certain properties of the matrices such as the number of girths of matrix **H** remain unchanged for all matrices of the family of matrices. Optimization on the selection of the shift values can be performed for a unique matrix **H** of the family of sparse parity matrices for different codeword lengths.

In particular for sub-matrices **B, D, E** and **T**, we select to restrain Level-3 non-zero blocks of size *w* to support only diagonal values, i.e. *t=1*. This has a direct implication that all shift values *s-1* are divisible by the Level-3 size $\varepsilon$ but also that Level-2 shift values *z* take only positive values since both z and t must have the same sign. As an example and considering the shift values *s* $\in$ *[-32, 32]* we have for sub-matrices **B, D, E** and **T**, the definition of a subset of these shift values given by shift values *z* $\in$ *[1; 8]* and *t=1*, i.e. the subset of shift values *s* $\in$ *{1, 5, 9, 13, 17, 21, 25, 29}*.

In a more general way, we can determine an integer value *L* satisfying the condition *L=$2^M$* with *M* $\in$ *[0, K-2]*. We can then use the value *L* to select a subset of the Level-2 positive shift values of z given for the maximum Level-2 size $\delta$*=$2^{K-1}$*, by taking those positive shift values *z-1* that are divisible by value *L*. Hence, for example, in **Figure 4**, we have considered the maximum Level-2 size to be *n=$2^3$=8* which implies that *K=4*. This provides the positive shift values *$z_8$={1, 2, 3, 4, 5, 6, 7, 8}*. We can than define a integer value *L=2* and determine the subset of values *$z_8$* such as each *$z_8$-1* value is divisible by *L=2* which gives the new subset *$z_8$={1, 3, 5, 7}*. Similarly, if we consider the integer value *L=4* we get the subset *$z_8$={1, 5}*. We notice that the integer value *L* is splitting the *$2^{K-1}$* by *$2^{K-1}$* Level-2 block into sub-blocks of size *L* by *L* that are either zero or have non-zero elements in its diagonal. However, since the size of Level-2 blocks *$v_n$=$2^n$* is given as a power of 2 and value *L=$2^M$* is also given as a power of 2, the selection operation of shift values *z* for *$2^{K-1}$* by *$2^{K-1}$* Level-2 blocks based on *L* determines those shift values *z* that can be obtained through a bijective operation for Level-2 blocks given for the cases *n=K-1-M* up to *n=K-1*. In fact, the value *L* serves to determine a subset of shift values *z* for which a re-dimensioning method can be applied to a Level-2 block of size *n-1* to a Level-2 block of size *n*. The operation to determine the shift value *$z_n$* from shift value *$z_{n-1}$* is given by the equation- *$z_n$ = 2·($z_{n-1}$-1)+1*. This re-dimensioning method corresponds to replace each element of a Level-2 block defined for a size given for *n-1* by a 2-by-2 element that is either the zero matrix or the diagonal matrix depending if the element of a Level-2 block which size is given for *n-1* is either 0 or 1 respectively. This re-dimensions the Level-2 blocks *$v_{n-1}$=$2^{n-1}$* to a Level-2 blocks *$v_n$=$2^n$*. Hence, from **Figure 4**, we notice that if *L=2*, given *$z_4$={1, 2, 3, 4}* we can deduce *$z_8$={1, 3, 5, 7}* and this operation is valid for *n=K-1-M=4-1-1=2* up to *n=K-1=4-1=3*. Notice that the above constraints maintain the characterization of shift values of a matrix of any value of $\delta$ by the shift values assigned for the highest Level-2 size $\delta$*=$2^{K-1}$*.

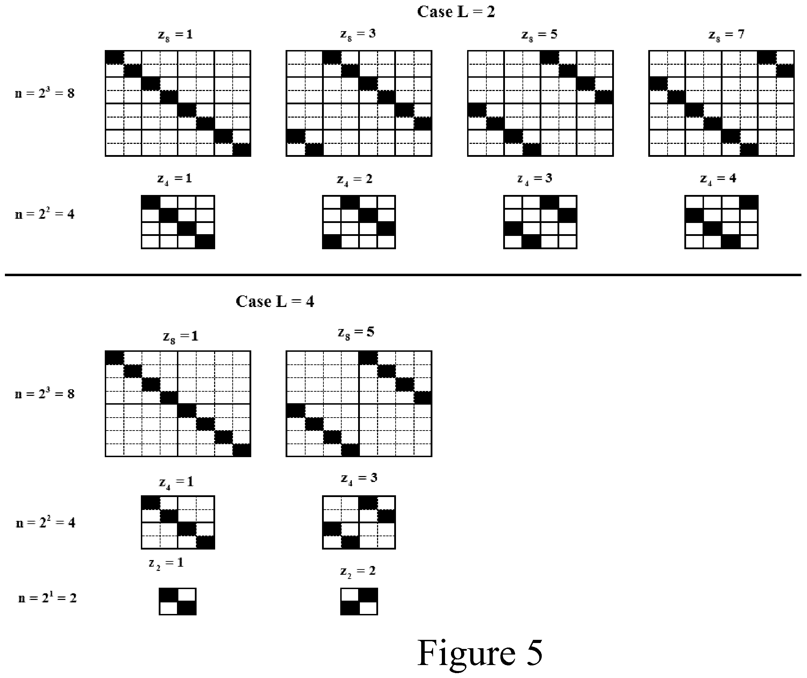

In our implementation example, we are considering both cases where *L=2* and *L=4* that are shown in **Figure 5**. This means that for sub-matrices **B, D, E** and **T** and from the positive shift values *z={1, 2, 3, 4, 5, 6, 7, 8}* we maintain the subset of shift values *z={1, 3, 5, 7}* when *L=2*. As *t =1*, we then have *s={1, 9, 17, 25}*. When *L=4,* then *z={1, 5}* and *s={1, 17}*. It is obvious that it is preferable to have a selection subset of shift values z under the above mentioned constraint as large as possible to maximize the diversity of Level-2 shift values in sub-matrices **B, D, E** and **T**. The additional selection of *L=4* is based on requirements for the support of operations for the case *n=2* and will be further analyzed below.

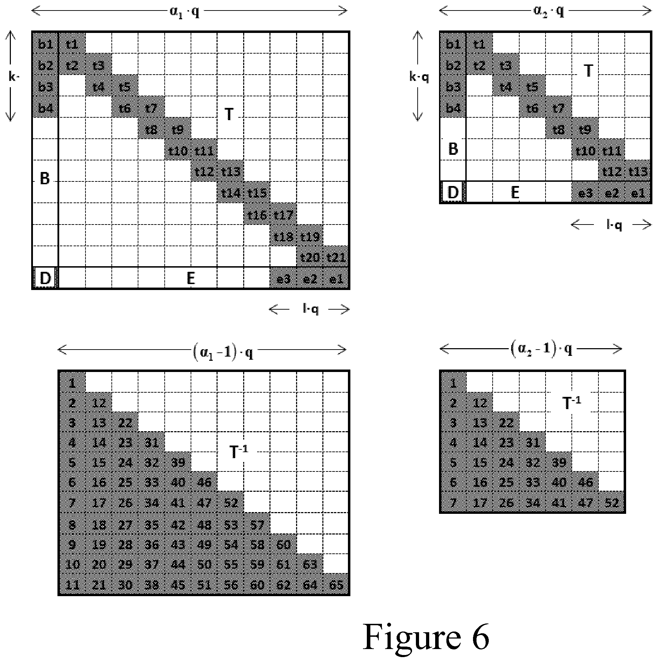

This constraint is particularly useful for matrix **T** in which we impose that all Level-1 shift values *b* are set to the value of *1*, i.e. non-zero Level-2 blocks of a non-zero Level-1 block of matrix **T** are those positioned on the diagonal of the Level-1 block. In this case, matrix **T$^{-1}$** is a lower triangular matrix with all non-zero Level-1 blocks having a shift values *b* equal to *1* as shown in **Figure 6.** From the above mentioned constraints, matrix **T** can be subdivided into blocks of a power of 2 of $\varepsilon$ which are either zeros or diagonals. The product and sum of these blocks is either a zero block or a diagonal block of size the same power of 2 of $\varepsilon$ in modulo-2 arithmetic. This condition serves to satisfy the condition that **T·T$^{-1}$** is equal to the identity matrix and impose that matrix **T$^{-1}$** can also be subdivided into blocks of size a power of 2 of $\varepsilon$ which are either zeros or diagonals. Therefore, it becomes possible to recover and represent matrix **T$^{-1}$** with Level-2 shift values that belong to the subset of possible Level-2 shift values of matrix **T** determined by the power of 2 given by *L*.

This particular point is extremely important since multiplication with matrix **T$^{-1}$** is used in several steps of the encoding process as we will see below. By constraining matrix **T** to be composed only of diagonal non-zero rectangular blocks of a power of 2 of $\varepsilon$, the rectangular non-zero blocks of the same power of 2 of $\varepsilon$ of **T$^{-1}$** are also diagonals. Therefore, for our implementation example, Level-2 shift values of blocks of **T$^{-1}$** belong also to *s={1, 9, 17, 25}* or *s={1, 17}* under the conditions determined above.

Finally, as mentioned above, the code rate of LDPC can be modified by modifying the value $\alpha$ of Level-1 columns from matrix **H**. We can determine a methodology to deduce the sub-matrices **B, D, E,** and **T** of a specific rate from the sub-matrices **B, D, E,** and **T** given for the minimum possible rate determined by the maximum value of $\alpha$. The maximum rate possible is obtained by the *max(k, l)* where *k* and *l* are the corresponding non-zero Level-1 *q* elements from matrices **B** and **E** respectively. The construction of new sub-matrices **B, D, E,** and **T** for a specific code rate is achieved by removing the bottom zero *j* Level-1 *q* blocks from matrices **T** and **B**. The same number *j* of columns of Level-1 blocks *q* is removed from the right of **T** and from the left of **E**. Matrix **D** is not modified.

The newly obtained sub-matrices **B, D, E,** and **T** are then combined in the right of matrix **H** assuring that *l* non-zeros Level-1 blocks are still present in matrix **E**.

The removal of the bottom rows and right columns of Level-1 blocks *q* of **T** is equivalent to the removal of the bottom rows and right columns Level-1 blocks *q* of **T$^{-1}$** and the condition where **T·T$^{-1}$** is equal to the identity matrix is satisfied. This is valid if the constraints previously described for **T** and **T$^{-1}$** are maintained. An example of such transformation is shown in **Figure 5** for a transformation from $\alpha_1$*=12* to $\alpha_2$*=8.* In this example, 4 zero Level-1 blocks of matrix **B** and for zero Level-1 blocks of matrix **E** are removed. Also, the bottom 4 rows and the 4 right columns of matrices **T** and **T$^{-1}$** are removed.

This last methodology is useful for the storage of only one set of matrices **B, D, E** and **T$^{-1}$** for all possible code rates supported for the system. In our implementation example since the maximum value of $\alpha$*=12,* we can store only the corresponding shift values of matrices **B, D, E** and **T$^{-1}$** for this rate and deduce the corresponding shift values of all other rates by taking subset of these shift values following the above mentioned methodology. Since the number of non-zero Level-1 blocks in **B** and **E** is 2 and 1 respectively, the minimum value of $\alpha$*=3* (due to *max(2, 1)=2* and the addition of matrix **D**).

Having decided the rates $\alpha$ supported by the system, different set of shift values for matrices **A** and **C** must be stored for all rates implemented. From the set of values of $\alpha$ and knowing that $\beta$ is fixed, the sizes of matrices **A** and **C** for all rates implemented can be deduced.

### *Encoder*

In general, the encoding operation in LDPC codes, in order to obtain codeword $\bar{c}$, is performed using the generator matrix **G** following the equation $\bar{c} = \bar{x} \cdot G$ with $\bar{x}$ being the information bit sequence, i.e. the block of data, to encode. However, the generator matrix **G** obtained from the sparse parity-check matrix **H** is usually dense and cannot be represented by cyclic permutations of blocks. To reduce storage and computation requirements, encoding can be performed by using the decomposition of **H** into sub-matrices and perform multiplications mainly with sparse sub-matrices of **H.** Hence, the computation of codeword $\bar{c}$ is obtained from the systematic part $\bar{x}$ and the computation of parity bits $\bar{p}_1$ and $\bar{p}_2$ with $\bar{p}_1$ of length *q,* and $\bar{p}_2$ of length *($\alpha$-1)·q.*

The parity bits $\bar{p}_1$ and $\bar{p}_2$ are derived from the information bits $\bar{x}$ following the relationships:

$$\bar{p}_1^T = \left(D + E \cdot T^{-1} \cdot B\right)^{-1} \cdot \left(C + E \cdot T^{-1} \cdot A\right) \cdot \bar{x}^T = \varphi^{-1} \cdot \left(C + E \cdot T^{-1} \cdot A\right) \cdot \bar{x}^T$$

with

$$\varphi = D + E \cdot T^{-1} \cdot B \text{ and } \overline{p}_2^T = \left( A \cdot T^{-1} \right) \cdot \overline{x}^T + \left( T^{-1} \cdot B \right) \cdot \overline{p}_1^T = T^{-1} \cdot \left[ A \cdot \overline{x}^T + B \cdot \overline{p}_1^T \right]$$

Using the block representation **of H,** we have:

$$H \cdot \overline{c}^T = \begin{bmatrix} A & B & T \\ C & D & E \end{bmatrix} \cdot \begin{bmatrix} \overline{x}^T \\ \overline{p}_1^T \\ \overline{p}_2^T \end{bmatrix} = \begin{bmatrix} A \cdot \overline{x}^T + B \cdot \overline{p}_1^T + T \cdot \overline{p}_2^T \\ C \cdot \overline{x}^T + D \cdot \overline{p}_1^T + E \cdot \overline{p}_2^T \end{bmatrix}$$

By replacing with the above mentioned values of $\mathbf{p_1}$ and $\mathbf{p_2}$, we get:

$$H \cdot \overline{c}^T = \begin{bmatrix} A \cdot \overline{x}^T + B \cdot \overline{p}_1^T + T \cdot T^{-1} \cdot \left[ A \cdot x^T + B \cdot \overline{p}_1^T \right] \\ C \cdot \overline{x}^T + D \cdot \overline{p}_1^T + E \cdot T^{-1} \cdot \left[ A \cdot x^T + B \cdot \overline{p}_1^T \right] \end{bmatrix} =$$

$$= \begin{bmatrix} A \cdot \overline{x}^T + B \cdot \overline{p}_1^T + \left[ A \cdot \overline{x}^T + B \cdot \overline{p}_1^T \right] \\ C \cdot \overline{x}^T + D \cdot \overline{p}_1^T + E \cdot T^{-1} \cdot \left[ A \cdot \overline{x}^T + B \cdot \overline{p}_1^T \right] \end{bmatrix} =$$

$$= \begin{bmatrix} 2 \cdot A \cdot x^T + 2 \cdot B \cdot \overline{p}_1^T \\ C \cdot \overline{x}^T + D \cdot \overline{p}_1^T + E \cdot T^{-1} \cdot A \cdot \overline{x}^T + E \cdot T^{-1} \cdot B \cdot \overline{p}_1^T \end{bmatrix} =$$

$$= \begin{bmatrix} 0 \\ \left( C + E \cdot T^{-1} \cdot A \right) \cdot \overline{x}^T + \left( D + E \cdot T^{-1} \cdot B \right) \cdot \overline{p}_1^T \end{bmatrix} =$$

$$= \begin{bmatrix} 0 \\ \left( C + E \cdot T^{-1} \cdot A \right) \cdot \overline{x}^T + \left( D + E \cdot T^{-1} \cdot B \right) \cdot \left( D + E \cdot T^{-1} \cdot B \right)^{-1} \left( C + E \cdot T^{-1} \cdot A \right) \cdot \overline{x}^T \end{bmatrix} =$$

$$= \begin{bmatrix} 0 \\ 2 \cdot \left( C + E \cdot T^{-1} \cdot A \right) \cdot \overline{x}^T \end{bmatrix} = \begin{bmatrix} 0 \\ 0 \end{bmatrix} = 0$$

Hence, using the relationships defined above for parity bits $\overline{\mathbf{p}}_1$ and $\overline{\mathbf{p}}_2$ we can obtain the equivalent codeword $\overline{\mathbf{c}}$ from the information block of data $\overline{\mathbf{x}}$.

The computation of the two parity check bits can be decomposed in the following steps:

**Step A1:**    $\overline{p}_{A1} = A \cdot \overline{x}^T$

**Step A2:**    $\overline{p}_{A2} = T^{-1} \cdot \overline{p}_{A1} = T^{-1} \cdot A \cdot \overline{x}^T$

**Step A3:**    $\overline{p}_{A3} = E \cdot \overline{p}_{A2} = E \cdot T^{-1} \cdot A \cdot \overline{x}^T$

**Step A4:**    $\overline{p}_{A4} = C \cdot \overline{x}^T$

**Step A5:**    $\overline{p}_{A5} = \overline{p}_{A4} + \overline{p}_{A3} = (C \cdot \overline{x}^T) + (E \cdot (T^{-1} \cdot (A \cdot \overline{x}^T)))$

**Step A6:**    $\overline{p}_1^T = \overline{p}_{A6} = \varphi^{-1} \cdot \overline{p}_{A5} = \varphi^{-1} \cdot \left[ \left( C \cdot \overline{x}^T \right) + \left( E \cdot \left( T^{-1} \cdot \left( A \cdot \overline{x}^T \right) \right) \right) \right]$

**Step B1:**    $\overline{p}_{B1} = A \cdot \overline{x}^T = \overline{p}_{A1}$

**Step B2:**    $\overline{p}_{B2} = B \cdot \left\{ \varphi^{-1} \cdot \left[ \left( C \cdot \overline{x}^T \right) + \left( E \cdot \left( T^{-1} \cdot \left( A \cdot \overline{x}^T \right) \right) \right) \right] \right\} = B \cdot \overline{p}_{A6} = B \cdot \overline{p}_1^T$

**Step B3:**    $\overline{p}_{B3} = \overline{p}_{B1} + \overline{p}_{B2} = A \cdot \overline{x}^T + B \cdot \{\varphi^{-1} \cdot [(C \cdot \overline{x}^T) + (E \cdot (T^{-1} \cdot (A \cdot \overline{x}^T)))]\}$

Step B4:    $\overline{p}_2^T = \overline{p}_{B4} = T^{-1} \cdot \overline{p}_{B3} = T^{-1} \cdot \left\{ A \cdot \overline{x}^T + B \cdot \left\{ \varphi^{-1} \cdot \left[ \left( C \cdot \overline{x}^T \right) + \left( E \cdot \left( T^{-1} \cdot \left( A \cdot \overline{x}^T \right) \right) \right) \right] \right\} \right\}$

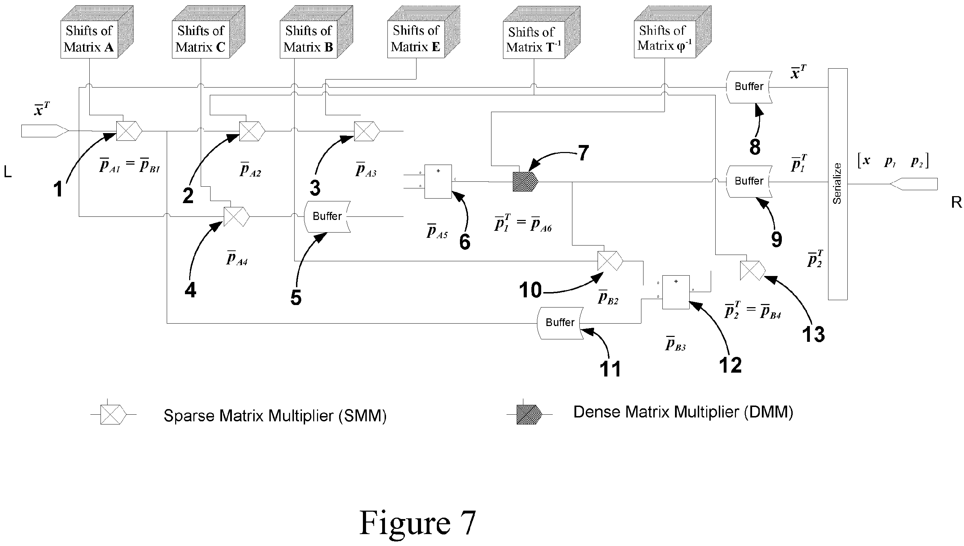

The schematic of the encoding process described above is described in **Figure 7.** Encoding operations are formed by a certain number of vector multiplication with a sparse matrix that according to the decomposition of **H** can be represented by a certain number of cyclic shift values, a couple of vector additions, certain buffering operations and a vector multiplication with a dense matrix that is required in **Step A6** only. We define by Sparse Matrix Multiplier (SMM) **1, 2, 4, 10, 13** the component that produces vector multiplication with a sparse matrix that can be represented by cyclic shift values as described in the above section. We define by Dense Matrix Multiplier (DMM) **6** the component that produces vector multiplication with a matrix that cannot be represented with cyclic shift values. We notice that Step **A1** and Step **B1** are identical and hence can be combined into a unique step under the condition of implementing a buffer since Step **B3** requires the output from Step **B2** which can be only completed after Step **A6**. In total, we require 4 different buffering operations for the completion of the encoding process. Additionally, there are 6 different matrix multiplications with sparse matrices, i.e. 6 SMM components, 2 vector additions and only 1 matrix multiplication with a dense matrix $\phi^{-1}$, i.e. only one DMM component.

The advantage of the decomposition of matrix **H** into sub-matrices lies in the fact that dense matrix multiplication is required only for a relatively small matrix of size equal to $q$. All remaining matrix multiplications are performed over sparse matrices which positions of 1's can be determined by shift values and cyclic permutations of block elements. Due to this structure of sparse matrices, optimization of the operations of the SMM component can be achieved. Below, we will demonstrate how with the above mentioned constraints on the definition of matrices **H** of variable codeword lengths and variable code rates can be implemented with a method and apparatus in accordance with the invention.

As mentioned, there are two distinct matrix multiplication components implemented in this invention: a sparse multiplication component called Sparse Matrix Multiplier (SMM) that is working on sparse matrices which non-zero values can be determined by cyclic permutation shift values and a dense multiplication component called Dense Matrix Multiplier (DMM) that works with a compressed form of the matrix to generate outputs of variable lengths according to the codeword length configuration.

In fact all encoding Steps, beside **Step A6,** are performed by multiplication of vector by a sparse matrix that can be represented by shift values. For all Steps of the encoding process, only matrices **A, C, T$^{-1}$, E,** and **B** are needed. Hence only the shift values of these matrices are stored for the encoding process and not the shift values of the entire matrix **H.** In particular, shift values of matrices **D** and **T** are not needed and therefore are not stored. In addition, as we have seen we can compute the shift values of smaller codeword lengths from the shift values of the highest codeword length for a given $K$. Hence, only the shift values of the highest codeword length are stored. We have also shown that for different code rates, i.e. values of $\alpha$, the equivalent matrices **T$^{-1}$, E,** and **B** can be obtained from the highest value of $\alpha$. Hence, for these matrices only one set of shift values for the highest value of $\alpha$ need to be stored. Different sets of shift values must be stored for different code rates only for matrices **A** and **C.** Hence, Sparse Matrix Multiplier (SMM) components of the encoding process are provided with the corresponding shift values of matrices **A** and **C** for the targeted rate and, shift values of **T$^{-1}$, E,** and **B** determined for the maximum value of $\alpha$ from which they deduce the subset of shift values to use based on the targeted rate. As we, will see, the Sparse Matrix Multiplier (SMM) components are processing these shift values by computing the shift values corresponding to the codeword length targeted.

### *Sparse Matrix Multiplier (SMM)*

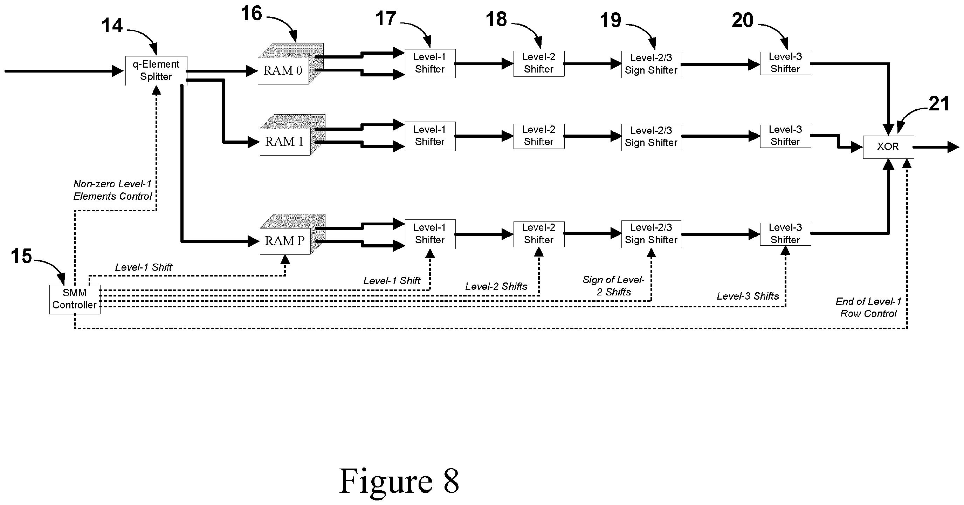

The encoding process for sparse matrices is performed by the Sparse Matrix Multiplier (SMM) **1, 2, 4, 10, 13** that is composed of parallelized components that process Level-1 blocks of each $q$ row of the sparse matrix in parallel. The parallelized components are composed of chains of components **16, 17, 18, 19, 20** each one formed of cascaded processors. Similar SMM entities or the same SMM entity can be used for all Steps of the encoding process described above given that no Step need to be performed in parallel with another. The SMM entity is provide with a different sparse matrix, i.e. the shift values of a different sparse matrix and the corresponding input vector for multiplication with this sparse matrix. The controller entity **15** of the SMM component is linked to each component **16, 17, 18, 19, 20** of the chains of components to provide the corresponding shift values. The diagram of the SMM entity **1, 2, 3, 4, 10, 13** is given in **Figure 8**. The processing operations of the SMM are performed in parallel by **P** parallelized encoding chains of components **16, 17, 18, 19, 20** with each chain performing the multiplication for a Level-1 block within a Level-1 $q$ row of the sparse matrix. The process of the **P** chains is repeated until all multiplication processes corresponding to the non-zero Level-1 blocks of a $q$ row are executed and then until all $q$ rows of the multiplier sparse matrix are completed. This implies that the SMM entity is operating over Level-1 rows of size $q$ and therefore sizes of the sparse matrix can be supported. The SMM entity is repeating its process independently for each Level-1 row of the sparse matrix. This implies that processing can be carried out for sparse matrices of different number of Level-1 rows and therefore different code rates can be supported since the number of Level-1 rows given by $\alpha$ is determining the rate of the LDPC encoder. This also implies that **P** non-zero Level-1 blocks of size $q$ in a row can be processed in parallel. The components of each the **P** chains are associated sequentially to process a different non-zero Level-1 $q$ block of a column of the Level-1 $q$ row under process. If the number of non-zero Level-1 $q$ blocks in the row under process is not divisible by **P** then certain of the encoding chains **P** are configured to perform no process.

For our implementation example, let's consider that **P=2,** i.e. there are only two parallel encoding chains **16, 17, 8, 19, 20** in **Figure 8** and therefore two Level-1 $q$ blocks can be processed in parallel. We can consider the implementation of **Step A1** where we have the multiplication of the information bit sequence $\bar{x}$ with the sparse matrix A. If the first Level-1 $q$ row of matrix **A** has, for example, **13** non-zero Level-1 $q$ blocks, then the 1st and 2nd Level-1 $q$ blocks are processed by the two encoding chains in parallel, then the 3rd and 4th Level-1 $q$ blocks are processed and so on. At the end of the first Level-1 $q$ row processing, the first encoding chain is processing the 13th non-zero Level-1 $q$ block while the second encoding chain is inactive and performs no encoding process. The outputs of the inactive encoding chains are set to be a sequence of zeros. The XOR operation at the end of the SMM entity corresponds to an addition of all outputs of the **P** chains. This corresponds to the addition of all multiplication operations of the **P** chains that correspond to the **P** multiplications of input sequences with the **P** non-zero Level-1 $q$ blocks. Hence, setting the outputs of the inactive chains to all zero values is similar of performing additions of only the outputs of the active encoding chains. All the above mentioned operations are controlled by the SMM controller **15** component that contains information about the size of sparse matrix, the zero and non-zero Level-1 blocks of the sparse matrix and the shift values of all non-zero blocks of the sparse matrix.

The initial step is to assign into each of the **P** RAM memories, the input data bits that correspond to the equivalent non-zero Level-1 block of the $q$ row under process by each of the **P** chains. Therefore, the input data bits are split by q-Element splitter **14** into consecutive sequence of input bits of size $q$ namely a packet of bits. The sequence of input bits corresponding to the non-zero Level-1 block of the $q$ of the row under process by the $g$ encoding chain is assigned to be stored in the RAM of the $g$ chain. Hence, if in the Level-1 $q$ row under process, the 1st and the 3rd Level-1 blocks are non-zero blocks, the 1st sequence of input bits are stored in RAM0 while the 3rd sequence of input bits is stored in RAM1.

The sizes of the memory elements of the **P** RAM memories including the size of the connection buses among components of the **P** chains is set to be constant and equal to the maximum size $R=v \cdot w=2^{K-1} \cdot \varepsilon$ supported by the system. Hence, the sequences of input bits of size $q$ are further subdivided into sets of sequences of size $R$ that are stored into the **P** RAM memories noticed as sequences of sets of a packet. In the case that a codeword length lower than the maximum supported by the system is selected, meaning that $v=2^N<2^{K-1},$ then the $R$ subsets are subdivided into subsets of $2^{N \cdot} \varepsilon$ defined as sets of the packets of bits. A certain number of such subsets can be left undetermined while the remaining subsets are filled with the input data bits of size $2^{N \cdot} \varepsilon.$ The selection of the number of subsets left undetermined meaning that they are filled with zeros and no values of input bits depends on the number of Level-2 blocks included in a Level-1 block, i.e. depending of the value of $\gamma.$ With this splitting and with $N<K-1 \cdot$ it becomes possible to process in each of the **P** chains simultaneously one or more Level-2 blocks including their underlying Level-3 blocks.

In our implementation example, we have $\delta \in \{1, 2, 4, 8\}$ and $w=\varepsilon=4.$ Hence, we can set $R=8 \cdot 4=32.$ When codeword length with $\delta=8$ is selected, the number of input data bits of a Level-1 block are $\gamma \cdot \delta \cdot \varepsilon=21 \cdot 8 \cdot 4=21 \cdot 32=672.$ We then split these input bits into $21$ sets of $R=32$ input bits. When codeword length with $\delta=4$ is selected, the number of input data bits of a Level-1 block are $\gamma \cdot \delta \cdot \varepsilon=21 \cdot 4 \cdot 4=21 \cdot 16=336.$ We can then split these input bits into $11$ sets of $R=32$ input bits in which $1$ of the $11$ sets contains only on subset of $16$ input bits. The other subset of $16$ bits of the set of $R=32$ bits is undetermined and filled with zeros. In our implementation example we split these input bits into $21$ sets of $R=32$ input bits in which all of the $21$ sets contains only $16$ input bits and in each set of $32$ bits there are $16$ input bits and $16$ undetermined bits that are filled with zeros. When codeword length with $\delta=2$ is selected, the number of input data bits of a Level-1 block are $\gamma \delta \varepsilon=21 \cdot 2 \cdot 4=21 \cdot 8=168.$ We can then split these input bits into $6$ sets of $R=32$ input bits in which $1$ of the $6$ sets contains only $8$ input bits and the other $24$ bits of this unique set are undetermined and filled with zeros. In our implementation example, we split these input bits into $7$ sets of $R=32$ input bits in which all of the $7$ sets contains $3 \cdot 8=24$ input bits meaning that in each set of $32$ bits there are $24$ input bits and $8$ undetermined bits that are filled with zeros. We then have $7 \cdot 3 \cdot 8=168$ input bits and $7 \cdot 1 \cdot 8=56$ undetermined bits. Finally, for codeword length with $\delta=1,$ the number of input data bits of a Level-1 block are $\gamma \delta \varepsilon=21 \cdot 2 \cdot 4=21 \cdot 4=84.$ In our implementation example, we split these input bits into 3 sets of $R=32$ input bits in which all of the 3 sets contains $7 \cdot 4=28$ input bits and in each set of 32 bits there are 28 input bits and $4$ undetermined bits that are filled with zeros. We then have $3 \cdot 7 \cdot 4=84$ input bits and $3 \cdot 1 \cdot 4=12$ undetermined bits.

Then, the controller is providing to the RAM component the sequence in which these sets of $R=32$ bits should be provided to Level-1 Shifter **17** based on the shift value $b$ of the non-zero Level-1 $q$ block under process by the specific encoding chain $g.$ The RAM component is providing two sets of $R=32$ bits, the one referenced by the controller and the immediately following set. When, the final set of $R=32$ bits is referenced, the RAM component is also providing the 1st set of $R=32$ bits. This operation is repeated until all sets of $R=32$ bits are referenced by the controller exactly once. These couple of sets of $R=32$ bits are provided to the Level-1 Shifter **17,** which is responsible to further process these data sets according to the codeword length selected. In fact, the shift value $b$ might require the recombination of subsets $2^{N \cdot} \varepsilon$ to guarantee the correct reordering of the subsets of size $2^{N \cdot} \varepsilon$ into the $R=32$ bits sets according to the cyclic shift value $b.$ This task is performed by the Level-1 Shifter **17** that recombine the subsets of $2^{N \cdot} \varepsilon$ bits from the provided two sets of **R=32** bits into a new set of **R=32** bits.

In our implementation example and assuming that the codeword length selected is $\delta$=8 and **R=32,** there are *21* sets of *32* input bits. Then, according to the shift value *b* these sets are subsequently transferred to the Level-1 Shifter **17**. For example, if *b=5,* the controller is referencing the 5th set and the couple of the 5th and 6th sets of **R=32** are transferred to the Level-1 Shifter **17** which outputs the 5th set. Then, the controller **15** is referencing the 6th set and the couple of the 6th and 7th sets of **R=32** are transferred to the Level-1 Shifter **17** which outputs the 6th set. This operation is repeated *21* times through referencing of all *21* sets of *32* input bits.

In the case, however, that $\delta$=2 or $\delta$=1, the sets of **R=32** input bits contain 3 or 7 subsets of *8* or *4* inputs bits respectively. Then, according to the shift value *b* a new composition of a set of **R=32** inputs bits is required. For example, for $\delta$=2, the first **R=32** bits set contains subsets *1, 2, 3* of *8* input bits, the second **R=32** bits set contains subsets *4, 5, 6* of *8* input bits and the third **R=32** bits set contains subsets *7, 8, 9* of *8* input bits. If *b=3,* than a new **R=32** bits set must be created from the 1st and 2nd **R=32** bit sets having subsets *3, 4, 5* of *8* input bits, i.e. taking subset number 3 from the 1st **R=32** bits set and subsets numbered *4* and *5* from the 2nd **R=32** bits subset. Then, the next **R=32** bits set must have subsets *6, 7, 8* of *8* input bits from the 2nd and 3rd **R=32** bits sets. This recombination of the operation is performed from the Level-1 Shifter **17** component based on the couple of **R=32** sets provided by the RAM component. The Level-1 Shifter **17** must be aware of the shift value *b* and the value of the codeword length selected given by $\delta$ in order to perform the correct recombination of the subsets from the **R=32** bit sets. Notice that as mentioned before we consider that there is one undetermined *8* bits subsets in the **R=32** bits sets in this implementation example. In general, shifters shift the values of the entries by a number of positions that is associated with the shift. The sign shifter reverses the order of the entries (flips) depending on the sign of the shift.

This methodology guarantees that storage size **R** of the data in the RAMs and that the connection buses among components is efficiently exploited by performing storage and transfers of several subsets of input bits even for the lower values of the codeword length. In addition, further parallelization is implemented when the encoding chain is working with *v·w<R.* As mentioned, the Level-1 Shifter **17** is processing several *v·w* blocks according to the ratio *R/(v·w).* The remaining components of each of the **P** encoding chains are also changed accordingly to processed several shift values following the number of subsets blocks *v·w* provided per chain at each instance.

This implies that for certain cases given for different codeword lengths such as in our implementation example for $\delta$=2 and $\delta$=1, several Level-2 blocks are processed simultaneously. For example, for $\delta$=2, in each set of *32* bits there are *3* subsets of *8* bits, i.e. there are input bits corresponding to 3 different Level-2 and Level-3 blocks. Hence, the controller **15** provides 3 different shift values to Level-2 Shifter **18,** Level-2/3 Sign Shifter **19** and Level-3 Shifter **20** components each one corresponding to the equivalent shift values of the Level-2 and Level-3 blocks included within the *32* bit set. Notice that since, from our design constraint the same shift value is applied to all Level-3 blocks included in a Level-2 block the shift values stored include the shift value of Level-3. This is achieved by providing the parts of the binary representation of the combined shift value *s* of Level-2 and Level-3 that has been described before. The binary part of the shift value *s* corresponding to the value of shift value z is provided to the Level-2 Shifter **18,** the sign of the shift value *s* is provided to the Level-2/3 Sign Shifter **19** while the binary part of the shift value *s* corresponding to the value of shift value *t* is provided to the Level-3 Shifter **20.**

The Level-2 Shifter **18** is then cyclically shifting the data bits according to the specified absolute *z* shift value. The Level-2/3 Sign Shifter block **19** is flipping the input data bits according to the sign of the combined shift s. The flipping operations for Level-2/3 Sign Shifter **19** components are performed over sets of bits over the sequence of bits of size *R* provided. Then, the Level-3 Shifter **20** is performing a cyclic shift of the **R** input data bits according to the *t* shift corresponding to Level-3 shift by operating in subsets of the input data bits of size *w.* The final operation is to perform a cumulative XOR of the output data bits of all encoding chains to produce the multiplied bits. This cumulative XOR is reset upon completion of all non-zero Level-1 blocks of each *q* row of the multiplication matrix. After the completion of the processing of a *q* row, this final component is removing the undetermined bits if included and issues the output bits for the multiplication of the *q* row of the sparse matrix with the input bits.

In our implementation example and assuming $\delta$=2, the Level-2 Shifter **18** is reordering (shifting) the *3* sets of *8* bits based on the absolute values of the 3 shift values *z* provided. Next, the Level-2/3 Sign Shifter **19** is flipping these sets of *8* bits according to the signs of the *3* shifts *s* provided. Then, for each of the *2* sets of *w=4* bits included in each set of *8* bits, cyclic shift is applied following the *3* values of the *t* shifts available. Notice that since the shifts values *z, s* and *t* are related as described above from our design selection, only one of these values must be provided to each components of the chain which in our case correspond to parts of the binary representation of shift s.

All the above operations correspond in fact to the multiplications required when a Level-1 *q* block of a matrix is multiplied with an input vector. In other words, in our implementation example, at each time the **R=32** outputs bits just before the XOR correspond to the multiplications of the *32, 16,* 24 or 28 rows of a Level-1 *q* block of the sparse matrix with the input vector. Upon completion of all multiplications of all sets of *32, 16,* 24 or 28 rows of a Level-1 *q* block, the **P** chains proceed to the multiplications corresponding to different non-zero Level-1 block in a *q* row of the sparse matrix. The cumulative XOR component is performing the additions corresponding to the matrix multiplication of a matrix by a vector by performing XOR operation of all sets of **R=32** received by the **P** chains at one time instance. Then, the cumulative XOR component is storing these values R=32 and repeat XOR operation for the next sets of **R=32** received by the **P** chains. This operation is repeated until all Level-2 and Level-3 blocks of the Level-1 blocks assigned to the **P** chains are completed. Then, the XOR operation is reiterated using the stored values until all non-zero Level-1 blocks of the *q* row are processed by the **P** chains. Then, the XOR component is output the output stored values after removal of the undetermined subset bits. For example, in our implementation, we can have **P=2** and in a *q* row of the sparse matrix *13* non-zero Level-1 *q* blocks. Then, according to the value $\delta$ giving the codeword length, i.e. *8, 4,* 2 or *1*, we have *21, 21, 7* or *3* sets respectively of **R=32** input bits for each Level-1 block processed by each of the **P** chains. The XOR component is going to perform a XOR operation for each of the *21, 21, 7* or *3* sets of *32* bits received from the **P** chains (XOR operation over the sets received) and store the outcome of *21, 21, 7* or *3* sets of *32* bits. These sets of *32* bits are going to be used by the XOR component for the next *21, 21, 7* or *3* sets of *32* input bits issued by the **P** chains after processing the next Level-1 blocks. This XOR operation is repeated **ceil(13/2)=7** times, with *ceil(.)* being the operation giving the smallest following integer of a real number, since while each of the *2* encoding chains are processing the *13* non-zero blocks in pairs of *2*. Finally, upon completion of the *q* row processing, the XOR component is output for each set of **R=32,** the corresponding *32, 16, 24* or 28 bits according to the value of $\delta$. Notice that at all times sets of *32* bits are processed by the XOR element **21** but only *32, 16, 24* or 28 of them correspond to output multiplication data. The controller **15** is providing to the XOR component **21** a signal that identifies that all non-zero Level-1 blocks of the *q* row have been processed and the value $\delta$ for the identification of the valid output bits in the sets of **R=32**.

The Dense Matrix Multiplier (DMM) is needed only for Step A6 of the encoding process. Any device component that can perform multiplication of a binary matrix with a vector can be used for this encoding step. Since the matrices and vectors provided in Step A6 depend on the codeword length selected several such devices might be needed.

**Claims**

1.  A method for Low-Density Parity Check processing of blocks of data bits comprising performing binary operations over each block of data based on a parity check matrix and encoding each block of data bits into a codeword having a number of bits, whereby the number of bits of the codeword defines the codeword length, whereby the method supports a maximum codeword length, whereby the parity check matrix is partitioned into a first level circulant blocks, and the first level circulant blocks are further partitioned into a second level circulant blocks and the second level circulant blocks are further partitioned into a third level circulant blocks, whereby each one of the circulant blocks of the first level, the second level and the third level is established by cyclic permutation of a diagonal or anti-diagonal matrix and is defined by a single shift parameter, whereby the binary operations include consecutive shifting operations, with each one of the shifting operations being associated with each one of the shift parameters of the first level blocks or the shift parameters of the second level blocks or the shift parameters of the third level blocks respectively, whereby the codeword length is controlled by the size of the the partition of the second level circulant blocks into third level circulant blocks, and whereby the method further comprises a) selecting the size of the partition of the second level circulant blocks into third level circulant blocks to select the codeword length for the encoding of each block of data bits, b) determining the shift parameters of the second level block using the shift parameters of the second level blocks that are associated with the said maximum codeword length and the said size of partition of the second level circulant blocks into third level circulant blocks for the selection of the codeword length and c) determining the shift parameters zm of the second level circulant blocks that are partitioned into m×m third level circulant blocks from the shift parameters zn of the second level circulant blocks that are partitioned into n×n third level circulant blocks, where n equals 2 times m, by the following equation:

$$\mathrm{zm} = sign\left(\mathrm{zn}\right) \cdot \left[ floor\left( \frac{|\mathrm{zn}| - 1}{2} \right) + 1 \right]$$

    where *sign* is the sign operation and *floor* is the floor operation of a real number, i.e. the larger integer not greater than the real number.

2.  A method according to claim 1, whereby the ratio of the number of bits in the block of data over the codeword length defines the code rate, the method further comprising:

    ✓ providing a first set of values appropriate to define the number of the first level circulant blocks across a column of the parity check matrix;

✓ selecting a first parameter among the first set of values to define the number of the first level circulant blocks across a column of the parity check matrix;
✓ performing the binary operations over each block of data based on the parity check matrix to obtain a codeword associated with the said block, whereby the code rate is controlled by the first parameter.

3. A method according to any one of claims **1 or 2,** whereby the shift values of third level circulant blocks that form a second level circulant block are the same and the said shift values of the third level circulant blocks and the said values of the second level circulant block being depended on a single common shift value.

4. A method according to any one of claims **1 to 3,** whereby the binary operations include flipping operations associated with the shift parameters of any one of the first level blocks, the second level blocks and the third level blocks, the flipping operations being performed between two consecutive shifting operations.

5. A method according to any one of claims **1 to 4,** comprising

✓ setting the size of subdivision of the first level blocks into second level blocks, i.e. the number of the second level blocks across a column or along a row of the first level blocks, to a constant value for all first level blocks;
✓ setting the size of third level blocks, i.e. the number of rows or columns of the third level blocks, to a constant value for all third level blocks;
✓ providing a set of appropriate values to define the size of the subdivision of the second level blocks to third level blocks, i.e. the number of the third level blocks across a column or along a row of the second level blocks; and
✓ selecting a value to define the size of the subdivision of the second level blocks among the set of appropriate values, so as to control the size of the first level blocks, i.e. the number of rows or columns of the first level blocks.

6. A method according to claim **5,** whereby the set of values to define the size of the subdivision of the second level blocks is restricted to values that equal to powers of 2.

7. A method according to claim **5 or 6,** comprising setting the size of the third level blocks equal to 4.

8. A method according to any one of claims **1 to 6,** including

✓ providing a master circulant block;
✓ selecting a number that defines how many third level circulant blocks are along a line of a second level circulant block; and
✓ determining the circulant blocks of the second level and the circulant blocks of the third level using the master circulant block and the said number.

9. An apparatus for Low-Density Parity Check encoding of blocks of data bits into a codeword having a number of bits, whereby the number of bits of the codeword defines the codeword length and the ratio of the number of bits in the block of data over the codeword length defines the code rate, the apparatus supports the encoding to a codeword with a maximum codeword length and comprises:

✓ processing means to encode packets of information bits, the processing means being configured to perform binary operations based on a parity check matrix that is partitioned into first level circulant blocks, and the first level circulant blocks are further partitioned into second level circulant blocks and the second level circulant blocks are further partitioned into third level circulant blocks, whereby each one of the circulant blocks of the first level, the second level and the third level is established by cyclic permutation of a diagonal or anti-diagonal matrix and defined by a single shift parameter;
✓ a controller configured to deliver the shift parameters that determine the first, second and third level of blocks to the processing means;
✓ means configured to receive a parameter that controls the size of the partition of the second level circulant blocks into third level circulant blocks and the codeword length;
✓ processing means configured to determine i) the shift parameters of the second level block using the shift parameters of the second level blocks that are associated with the said maximum codeword length and the said parameter that controls the size of the partition of the second level circulant blocks into third level circulant blocks and the codeword length and ii) the shift parameters $zm$ of the second level circulant blocks that are partitioned into $m \times m$ third level circulant blocks from the shift parameters $zn$ of the second level circulant blocks that are partitioned into $n \times n$ third level circulant blocks, where n equals 2 times m, by the equation

$$zm = sign\,(\text{zn}) \cdot \left[ floor\left(\frac{|\text{zn}| - 1}{2}\right) + 1 \right]$$

where *sign* is the sign operation and *floor* is the floor operation of a real number, i.e. the larger integer not greater than the real number.

10. An apparatus according to claim 9, comprising means to control the code rate including input means configured to receive a parameter that defines the number of first level rectangular blocks across a column of the parity check matrix, whereby the processing means are further configured to deliver a codeword with a code rate controlled by the parameter that defines the number of first level rectangular blocks across a column of the parity check matrix.

11. An apparatus according to claim **9 or 10,** comprising means to store a master circulant block and processing means configured to calculate the shift parameters of the circulant blocks of the second level and the circulant blocks of the third level on the basis of the master circulant block.

12. The apparatus according to any one of claims **9 to 11,** comprising a sparse matrix multiplier **(1, 2, 3, 4, 10, 13)** having a chain of components **(16, 17, 18, 19, 20),** whereby the components include, memory means **(16)** configured to store packets of information bits and a plurality of cascaded processing means **(17, 18, 19, 20)** configured to base the encoding binary operations on the shift parameters of the circulant blocks of the first level, the second level and the third level, the sparse matrix multiplier **(1, 2, 3, 4, 10, 13)** further comprising a controller **(15)** configured to provide the shift parameters to the chain of processing means.

13. The apparatus of claim **12,** comprising means configured to receive the output from the sparse matrix multiplier and redirect it to the same sparse matrix multiplier for further shifting operations.

14. The apparatus of claim **12 or 13,** comprising a plurality of similar sparse matrix multipliers.

**Patentansprüche**

1. Verfahren zur Low-Density Parity Check-Verarbeitung von Datenblockbitblöcken, umfassend Durchführen von binären Funktionen über jedem Datenblock, basierend auf einer Paritätsprüfungsmatrix und Codieren jedes Datenbitblocks in ein Codewort, das eine Zahl von Bits aufweist, wobei die Zahl von Bits des Codeworts die Codewortlänge definiert, wobei das Verfahren eine maximale Codewortlänge unterstützt, wobei die Paritätsprüfungsmatrix in zirkulante Blöcke erster Ebene unterteilt ist und die zirkulanten Blöcke erster Ebene weiter in zirkulante Blöcke zweiter Ebene unterteilt sind und die zirkulanten Blöcke zweiter Ebene weiter in zirkulante Blöcke dritter Ebene unterteilt sind, wobei jeder der zirkulanten Blöcke der ersten Ebene, der zweiten Ebene und der dritten Ebene durch zyklische Permutation einer diagonalen oder antidiagonalen Matrix eingerichtet und durch einen einzelnen Verschiebungsparameter definiert ist, wobei die binären Funktionen aufeinanderfolgende Verschiebungsfunktionen beinhalten, wobei jeder der Verschiebungsfunktionen mit jedem einzelnen der Verschiebungsparameter der Blöcke erster Ebene oder der Verschiebungsparameter der Blöcke zweiter Ebene beziehungsweise der Verschiebungsparameter der Blöcke dritter Ebene verknüpft ist, wobei die Codewortlänge von der Größe der Unterteilung der zirkulanten Blöcke zweiter Ebene in zirkulante Blöcke dritter Ebene gesteuert wird und wobei das Verfahren weiter umfasst a) Auswählen der Größe der Unterteilung der zirkulanten Blöcke zweiter Ebene in zirkulante Blöcke dritter Ebene, um die Codewortlänge für die Codierung jedes Datenbitblocks auszuwählen, b) Ermitteln der Verschiebungsparameter des Blocks zweiter Ebene unter Verwendung der Verschiebungsparameter der Blöcke zweiter Ebene, die mit der maximalen Codewortlänge verknüpft sind, und der Unterteilungsgröße der zirkulanten Blöcke zweiter Ebene in zirkulante Blöcke dritter Ebene für die Auswahl der Codewortlänge und c) Ermitteln der Verschiebungsparameter zm der zirkulanten Blöcke zweiter Ebene, die in mxm zirkulante Blöcke dritter Ebene unterteilt sind, aus den Verschiebungsparametern zn der zirkulanten Blöcke zweiter Ebene, die in nxn zirkulante Blöcke dritter Ebene unterteilt sind, wo n gleich 2 mal m ist, durch die folgende Gleichung:

$$zm = sign(zn) \cdot \left[ floor\left(\frac{|zn| - 1}{2}\right) + 1 \right]$$

wo *sign* die Vorzeichenfunktion ist und *floor* die Abrundungsfunktion einer reellen Zahl ist, d.h. die größere Ganzzahl, die nicht größer als die reelle Zahl ist.

2. Verfahren nach Anspruch 1, wobei das Verhältnis der Zahl von Bits in dem Datenblock über die Codewortlänge die Codefrequenz definiert, wobei das Verfahren weiter umfasst:

- Bereitstellen einer ersten Wertemenge, die geeignet ist, die Zahl der zirkulanten Blöcke erster Ebene über eine Spalte der Paritätsprüfungsmatrix zu definieren;
- Auswählen eines ersten Parameters unter der ersten Wertemenge, um die Zahl der zirkulanten Blöcke erster Ebene über eine Spalte der Paritätsprüfungsmatrix zu definieren;
- Durchführen der binären Funktionen über jeden Datenblock, basierend auf der Paritätsprüfungsmatrix, um ein Codewort zu erhalten, das mit dem Block verknüpft ist, wobei die Codefrequenz von dem ersten Parameter gesteuert wird.

3. Verfahren nach einem der Ansprüche 1 oder 2, wobei die Verschiebungswerte der zirkulanten Blöcke dritter Ebene, die einen zirkulanten Block zweiter Ebene bilden, dieselben sind und die Verschiebungswerte der zirkulanten Blöcke dritter Ebene und die Werte des zirkulanten Blocks zweiter Ebene von einem einzelnen gemeinsamen Verschiebungswert abhängen.

4. Verfahren nach einem der Ansprüche 1 bis 3, wobei die binären Funktionen Flipping-Funktionen beinhalten, die mit den Verschiebungsparametern eines beliebigen der Blöcke erster Ebene, der Blöcke zweiter Ebene und der Blöcke dritter Ebene verknüpft sind, wobei die Flipping-Funktionen zwischen zwei aufeinanderfolgenden Verschiebungsfunktionen durchgeführt werden.

5. Verfahren nach einem der Ansprüche 1 bis 4, umfassend

- Einstellen der Untergliederung der Blöcke erster Ebene in Blöcke zweiter Ebene, d.h. der Zahl der Blöcke zweiter Ebene über eine Spalte oder entlang einer Reihe der Blöcke erster Ebene, auf einen konstanten Wert für alle Blöcke erster Ebene;
- Einstellen der Größe von Blöcken dritter Ebene, d.h. der Zahl von Reihen oder Spalten der Blöcke dritter Ebene, auf einen konstanten Wert für alle Blöcke dritter Ebene;
- Bereitstellen einer Menge von geeigneten Werten, um die Größe der Untergliederung der Blöcke zweiter Ebene zu Blöcken dritter Ebene, d.h. die Zahl der Blöcke dritter Ebene über eine Spalte oder entlang einer Reihe der Blöcke zweiter Ebene, zu definieren; und
- Auswählen eines Wertes, um die Größe der Untergliederung der Blöcke zweiter Ebene unter der Menge von geeigneten Werten zu definieren, um die Größe der Blöcke erster Ebene zu steuern, d.h. die Zahl von Reihen oder Spalten der Blöcke erster Ebene.

6. Verfahren nach Anspruch 5, wobei die Wertemenge, um die Größe der Untergliederung der Blöcke zweiter Ebene zu definieren, auf Werte begrenzt ist, die Potenzen von 2 gleich sind.

7. Verfahren nach Anspruch 5 oder 6, umfassend Einstellen der Größe der Blöcke dritter Ebene gleich 4.

8. Verfahren nach einem der Ansprüche 1 bis 6, beinhaltend

- Bereitstellen eines zirkulanten Masterblocks;
- Auswählen einer Zahl, die definiert, wie viele zirkulante Blöcke dritter Ebene entlang einer Linie eines zirkulanten Blocks zweiter Ebene liegen; und
- Ermitteln der zirkulanten Blöcke der zweiten Ebene und der zirkulanten Blöcke der dritten Ebene unter Verwendung des zirkulanten Masterblocks und der Zahl.

9. Einrichtung für Low-Density Parity Check-Codierung von Datenbitblöcken in ein Codewort, das eine Zahl von Bits aufweist, wobei die Zahl von Bits des Codeworts die Codewortlänge definiert und das Verhältnis der Zahl von Bits in dem Datenblock über die Codewortlänge die Codefrequenz definiert, wobei die Einrichtung die Codierung eines Codeworts mit einer maximalen Codewortlänge unterstützt und umfasst:

- Verarbeitungsmittel zum Codieren von Paketen von Informationsbits, wobei die Verarbeitungsmittel konfiguriert sind, binäre Funktionen basierend auf einer Paritätsprüfungsmatrix durchzuführen, die in zirkulante Blöcke erster Ebene unterteilt ist und die zirkulanten Blöcke erster Ebene weiter in zirkulante Blöcke zweiter Ebene unterteilt sind und die zirkulanten Blöcke zweiter Ebene weiter in zirkulante Blöcke dritter Ebene unterteilt sind, wobei jeder der zirkulanten Blöcke der ersten Ebene, der zweiten Ebene und der dritten Ebene durch zyklische Permutation einer diagonalen oder antidiagonalen Matrix eingerichtet und durch einen einzelnen Verschiebungsparameter definiert ist;

- eine Steuerung, die konfiguriert ist, die Verschiebungsparameter, die die Blöcke erster, zweiter und dritter Ebene ermitteln, an das Verarbeitungsmittel zu liefern;

- Mittel, die konfiguriert sind, einen Parameter zu empfangen, der die Größe der Unterteilung der zirkulanten Blöcke zweiter Ebene in zirkulante Blöcke dritter Ebene und die Codewortlänge steuert;

- Verarbeitungsmittel, die konfiguriert sind zu ermitteln i) der Verschiebungsparameter des Blocks zweiter Ebene unter Verwendung der Verschiebungsparameter der Blöcke zweiter Ebene, die mit der maximalen Codewortlänge verknüpft sind, und des Parameters, der die Größe der Unterteilung der zirkulanten Blöcke zweiter Ebene in zirkulante Blöcke dritter Ebene und die Codewortlänge steuert und ii) der Verschiebungsparameter zm der zirkulanten Blöcke zweiter Ebene, die in mxm zirkulante Blöcke dritter Ebene unterteilt sind, aus den Verschiebungsparametern der zirkulanten Blöcke zweiter Ebene, die in nxn zirkulante Blöcke dritter Ebene unterteilt

$$zm = sign(zn) \cdot \left[ floor\left(\frac{|zn|-1}{2}\right) + 1 \right],$$

sind, wo n gleich 2 mal m ist, durch die Gleichung wo *sign* die Vorzeichenfunktion ist und *floor* die Abrundungsfunktion einer reellen Zahl ist, d.h. die größere Ganzzahl, die nicht größer als die reelle Zahl ist.

10. Einrichtung nach Anspruch 9, umfassend Mittel zum Steuern der Codefrequenz, beinhaltend Eingangsmittel, die konfiguriert sind, einen Parameter zu empfangen, der die Zahl von rechteckigen Blöcken erster Ebene über eine Spalte der Paritätsprüfungsmatrix definiert, wobei die Verarbeitungsmittel weiter konfiguriert sind, ein Codewort mit einer Codefrequenz zu liefern, die von dem Parameter gesteuert ist, der die Zahl von rechteckigen Blöcken erster Ebene über eine Spalte der Paritätsprüfungsmatrix definiert.

11. Einrichtung nach Anspruch **9 oder 10,** umfassend Mittel zum Speichern eines zirkulanten Masterblocks und Verarbeitungsmittel, die konfiguriert sind, die Verschiebungsparameter der zirkulanten Blöcke der zweiten Ebene und die zirkulanten Blöcke der dritten Ebene auf der Basis des zirkulanten Masterblocks zu berechnen.

12. Einrichtung nach einem der Ansprüche **9 bis 11,** umfassend einen dünnbesetzten Matrix-Multiplizierer **(1, 2, 3, 4, 10, 13),** der eine Kette von Komponenten **(16, 17, 18, 19, 20)** aufweist, wobei die Komponenten Speichermittel **(16),** die konfiguriert sind, Informationsbitpakete zu speichern, und eine Vielzahl von kaskadierten Verarbeitungsmitteln **(17, 18, 19, 20)** aufweisen, die konfiguriert sind, die binären Codierungsfunktionen auf den Verschiebungsparametern der zirkulanten Blöcke der ersten Ebene, der zweiten Ebene und der dritten Ebene zu basieren, wobei der dünnbesetzte Matrix-Multiplizierer **(1, 2, 3, 4, 10, 13)** weiter eine Steuerung **(15)** umfasst, die konfiguriert ist, die Verschiebungsparameter der Kette von Verarbeitungsmitteln bereitzustellen.

13. Einrichtung nach Anspruch **12,** umfassend Mittel, die konfiguriert sind, den Ausgang von dem dünnbesetzten Matrix-Multiplizierer zu empfangen und ihn zu demselben dünnbesetzten Matrix-Multiplizierer für weitere Verschiebungsfunktionen umzuleiten.

14. Einrichtung nach Anspruch **12 oder 13,** umfassend eine Vielzahl ähnlicher dünnbesetzter Matrix-Multiplizierer.

**Revendications**

1. Procédé de traitement de vérification de parité à faible densité de blocs de bits de données comprenant les étapes consistant à effectuer des opérations binaires sur chaque bloc de données sur la base d'une matrice de vérification de parité et à coder chaque bloc de bits de données en un mot de code présentant un nombre de bits, selon lequel le nombre de bits du mot de code définit la longueur de mot de code, selon lequel le procédé supporte une longueur de mot de code maximale, selon lequel la matrice de vérification de parité est divisée en blocs circulants de premier niveau, et les blocs circulants de premier niveau sont en outre divisés en blocs circulants de deuxième niveau et les blocs circulants de deuxième niveau sont en outre divisés en blocs circulants de troisième niveau, selon lequel chacun des blocs circulants du premier niveau, du deuxième niveau et du troisième niveau est établi par une permutation cyclique d'une matrice diagonale ou antidiagonale et est défini par un paramètre de changement unique, selon lequel les opérations binaires incluent des opérations de changement consécutives, avec chacune des opérations de changement étant associée à chacun des paramètres de changement des blocs de premier niveau ou des paramètres de changement des blocs de deuxième niveau ou des paramètres de changement des blocs de troisième niveau respectivement, selon lequel la longueur de mot de code est commandée par la taille de la division des blocs circulants de deuxième niveau en blocs circulants de troisième niveau, et selon lequel le procédé comprend en outre les étapes consistant à a) sélectionner la taille de la division des blocs circulants de deuxième niveau en blocs circulants de troisième niveau pour sélectionner la longueur de mot de code pour le codage de chaque bloc de bits de données, b) déterminer les paramètres de changement du bloc de deuxième niveau en utilisant les paramètres de changement des blocs de deuxième niveau qui sont associés à ladite longueur de mot de code maximale et à ladite taille de division des blocs circulants de deuxième niveau en blocs circulants de troisième niveau pour la sélection de la longueur de mot de code et c) déterminer les paramètres de changement zm des blocs circulants de deuxième niveau qui sont divisés en m × m blocs circulants de troisième niveau à partir des paramètres de changement zn des blocs circulants de deuxième niveau qui sont divisés en n × n blocs circulants de troisième niveau, où n est égal à 2 fois m, par l'équation suivante :

$$zm = sign(zn) \cdot \left[ floor\left( \frac{|zn| - 1}{2} \right) + 1 \right]$$

où *sign* est l'opération de signe et *floor* est l'opération de sol d'un nombre réel, c.-à-d. le nombre entier le plus élevé non supérieur au nombre réel.

2. Procédé selon la revendication 1, selon lequel le rapport entre le nombre de bits dans le bloc de données et la longueur de mot de code définit le débit de code, le procédé comprenant en outre les étapes consistant à :

   ✓ fournir un premier ensemble de valeurs appropriées pour définir le nombre des blocs circulants de premier niveau dans une colonne de la matrice de vérification de parité ;
   ✓ sélectionner un premier paramètre parmi le premier ensemble de valeurs pour définir le nombre des blocs circulants de premier niveau dans une colonne de la matrice de vérification de parité ;
   ✓ effectuer les opérations binaires sur chaque bloc de données sur la base de la matrice de vérification de parité pour obtenir un mot de code associé audit bloc, selon lequel le débit de code est commandé par le premier paramètre.

3. Procédé selon l'une quelconque des revendications **1 ou 2,** selon lequel les valeurs de changement de blocs circulants de troisième niveau qui forment un bloc circulant de deuxième niveau sont identiques et lesdites valeurs de changement des blocs circulants de troisième niveau et lesdites valeurs du bloc circulant de deuxième niveau étant dépendantes d'une valeur de changement commune unique.

4. Procédé selon l'une quelconque des revendications **1 à 3,** selon lequel les opérations binaires incluent des opérations de retournement associées aux paramètres de changement de l'un quelconque parmi les blocs de premier niveau, les blocs de deuxième niveau et les blocs de troisième niveau, les opérations de retournement étant effectuées entre deux opérations de changement consécutives.

5. Procédé selon l'une quelconque des revendications **1 à 4,** comprenant les étapes consistant à

   ✓ fixer la taille de sous-division des blocs de premier niveau en blocs de deuxième niveau, c.-à-d. le nombre des blocs de deuxième niveau dans une colonne ou le long d'une rangée des blocs de premier niveau, sur une valeur constante pour tous les blocs de premier niveau ;
   ✓ fixer la taille de blocs de troisième niveau, c.-à-d. le nombre de rangées ou de colonnes des blocs de troisième niveau, sur une valeur constante pour tous les blocs de troisième niveau ;
   ✓ fournir un ensemble de valeurs appropriées pour définir la taille de la sous-division des blocs de deuxième niveau en blocs de troisième niveau, c.-à-d. le nombre des blocs de troisième niveau dans une colonne ou le long d'une rangée des blocs de deuxième niveau ; et
   ✓ sélectionner une valeur pour définir la taille de la sous-division des blocs de deuxième niveau parmi l'ensemble de valeurs appropriées, de manière à commander la taille des blocs de premier niveau, c.-à-d. le nombre de rangées ou de colonnes des blocs de premier niveau.

6. Procédé selon la revendication **5,** selon lequel l'ensemble de valeurs pour définir la taille de la sous-division des blocs de deuxième niveau est limité à des valeurs qui sont égales à des puissances de 2.

7. Procédé selon la revendication **5 ou 6,** comprenant l'étape consistant à fixer la taille des blocs de troisième niveau égale à 4.

8. Procédé selon l'une quelconque des revendications **1 à 6,** incluant les étapes consistant à

   ✔ fournir un bloc circulant maître ;
   ✔ sélectionner un nombre qui définit combien de blocs circulants de troisième niveau sont le long d'une ligne d'un bloc circulant de deuxième niveau ; et
   ✔ déterminer les blocs circulants du deuxième niveau et les blocs circulants du troisième niveau en utilisant le bloc circulant maître et ledit nombre.

9. Appareil de codage de vérification de parité à faible densité de blocs de bits de données en un mot de code ayant un nombre de bits, selon lequel le nombre de bits du mot de code définit la longueur de mot de code et le rapport entre le nombre de bits dans le bloc de données et la longueur de mot de code définit le débit de code, l'appareil supporte le codage en un mot de code avec une longueur de mot de code maximale et comprend :

   ✔ un moyen de traitement pour coder des paquets de bits d'informations, le moyen de traitement étant configuré pour effectuer des opérations binaires sur la base d'une matrice de vérification de parité qui est divisée en blocs circulants de premier niveau, et les blocs circulants de premier niveau sont en outre divisés en blocs circulants de deuxième niveau et les blocs circulants de deuxième niveau sont en outre divisés en blocs circulants de troisième niveau, selon lequel chacun des blocs circulants du premier niveau, du deuxième niveau et du troisième niveau est établi par une permutation cyclique d'une matrice diagonale ou antidiagonale et défini par un paramètre de changement unique ;
   ✔ un dispositif de commande configuré pour délivrer les paramètres de changement qui déterminent les premier, deuxième et troisième niveaux de blocs au moyen de traitement ;
   ✔ un moyen configuré pour recevoir un paramètre qui commande la taille de la division des blocs circulants de deuxième niveau en blocs circulants de troisième niveau et la longueur de mot de code ;
   ✔ un moyen de traitement configuré pour déterminer i) les paramètres de changement du bloc de deuxième niveau en utilisant les paramètres de changement des blocs de deuxième niveau qui sont associés à ladite longueur de mot de code maximale et audit paramètre qui commande la taille de la division des blocs circulants de deuxième niveau en blocs circulants de troisième niveau et la longueur de mot de code et ii) les paramètres de changement zm des blocs circulants de deuxième niveau qui sont divisés en m $\times$ m blocs circulants de troisième niveau à partir des paramètres de changement zn des blocs circulants de deuxième niveau qui sont divisés en n $\times$ n blocs circulants de troisième niveau, où n est égal à 2 fois m, par l'équation *zm = sign(zn)* ·

   $$\left[ floor\left( \frac{|zn|-1}{2} \right) + 1 \right]$$

   où *sign* est l'opération de signe et *floor* est l'opération de sol d'un nombre réel, c.-à-d. le nombre entier le plus élevé non supérieur au nombre réel.

10. Appareil selon la revendication 9, comprenant un moyen de commander le débit de code incluant un moyen d'entrée configuré pour recevoir un paramètre qui définit le nombre de blocs rectangulaires de premier niveau dans une colonne de la matrice de vérification de parité, selon lequel le moyen de traitement est en outre configuré pour délivrer un mot de code avec un débit de code commandé par le paramètre qui définit le nombre de blocs rectangulaires de premier niveau parmi une colonne de la matrice de vérification de parité.

11. Appareil selon la revendication **9 ou 10,** comprenant un moyen de stocker un bloc circulant maître et un moyen de traitement configuré pour calculer les paramètres de changement des blocs circulants du deuxième niveau et des blocs circulants du troisième niveau sur la base du bloc circulant maître.

12. Appareil selon l'une quelconque des revendications **9 à 11,** comprenant un multiplicateur de matrice creuse **(1, 2, 3, 4, 10, 13)** présentant une chaîne de composants **(16, 17, 18, 19, 20),** selon lequel les composants incluent un moyen de mémoire **(16)** configuré pour stocker des paquets de bits d'informations et une pluralité de moyens de traitement en cascade **(17, 18, 19, 20)** configurés pour baser les opérations binaires de codage sur les paramètres de changement des blocs circulants du premier niveau, du deuxième niveau et du troisième niveau, le multiplicateur de matrice creuse **(1, 2, 3, 4, 10, 13)** comprenant en outre un dispositif de commande **(15)** configuré pour fournir les paramètres de changement à la chaîne de moyens de traitement.

13. Appareil selon la revendication **12,** comprenant un moyen configuré pour recevoir la sortie du multiplicateur de matrice creuse et la rediriger vers le même multiplicateur de matrice creuse pour des opérations de changement supplémentaires.

14. Appareil selon la revendication **12 ou 13,** comprenant une pluralité de multiplicateurs de matrice creuse similaires.

Figure 1

EP 2 951 925 B1

q-Element in Matrix H

r-Element in q-Element

u-Element in r-Element

Figure 2

Figure 3

EP 2 951 925 B1

Figure 4

Figure 5

Figure 6

Figure 7

Figure 8

EP 2 951 925 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006062351 A

**Non-patent literature cited in the description**

- **THOMAS J. RICHARDSON ; RÜDIGER L. UR-BANKE.** Efficient Encoding of Low-Density Parity-Check Codes. *IEEE Transactions on Information Theory,* February 2001, vol. 47 (2), 638-656